# EUROPEAN PATENT SPECIFICATION

(11) **EP 3 786 560 B1**
(45) Date of publication and mention of the grant of the patent: **12.01.2022**
(21) Application number: 19315106.5
(22) Date of filing: 30.08.2019
(51) Int. Cl.: F28D 1/053, F28D 1/02, F28D 1/047, F28F 1/32, F28D 1/04, F28D 21/00, F28F 9/22

(54) **HEAT EXCHANGER ASSEMBLY**
WÄRMETAUSCHERANORDNUNG
ENSEMBLE ÉCHANGEUR THERMIQUE

(43) Date of publication of application: 03.03.2021
(73) Proprietor: OVH, 59100 Roubaix (FR)
(72) Inventor: CHAKIR, Anas, 59250 Halluin (FR); BAUDUIN, Hadrien, 59650 Villeneuve d'Ascq (FR); CHENADE, Ali, 59242 Templeuve (FR); KLABA, Henryk, 59100 Roubaix (FR)
(74) Representative: BCF Global

(56) References cited:
- CN-A- 1 782 601
- CN-A- 104 654 825
- US-A- 4 691 766
- US-A1- 2012 279 689
- US-A1- 2014 262 147
- US-A1- 2017 292 789

## Description

### FIELD OF TECHNOLOGY

The present disclosure relates to heat exchanger assemblies such as dry coolers.

### BACKGROUND

Heat exchanger assemblies are used to evacuate heat from environments that require a generally cool operating temperature. For instance, data centers typically rely on heat exchanger assemblies such as dry coolers to provide adequate cooling to the electronic devices (e.g., servers and others) operating therein. However, since dry coolers are installed outside of the data centers (e.g., on their roofs) to evacuate heated air into the surroundings, operation of dry coolers in populated areas can be problematic due to their high levels of sound emission which can be bothersome to inhabitants in the vicinity thereof.

Typically, sound emission from a heat exchanger assembly such as a dry cooler mainly results from the suction of air at the level of the dry cooler's fan impellers where heated air is aspirated from an interior space of the dry cooler and discharged therefrom. Notably, sound emissions have been found to be generated both at the "entrance" of the fan impellers (where air flow traverses the fan impellers) and at the "exit" thereof (where air flow is expelled by the fan impellers). As such, many solutions have been proposed to address this problem, including devices which are attached to the heat exchanger assembly for treatment of air flow at both the exit and entrance of the fan impellers. However, these devices tend to be bulky and add to the height of the heat exchanger assembly, which makes it impractical. In addition, these solutions can be expensive to implement and due to their significant size, difficult to install (in some cases needing heavy lifting equipment such as a crane). In some cases, outer acoustic barriers have been implemented to surround or even completely enclose a dry cooler. However, such acoustic barriers are also expensive and have a significant footprint and thus take up a lot of otherwise usable space, making it a less than ideal solution.

Furthermore, while it is generally desirable to maximize the size of the fans of a dry cooler to increase its efficiency, this tends to even further exacerbate the already significant levels of sound emission of the dry cooler. In a similar manner, reducing the width of the dry cooler assembly to have a more compact and convenient dry cooler can have a detrimental effect on its sound emission as the fan becomes bigger in comparison.

Similar problems may apply to other types of heat exchanger assemblies (e.g., a chiller, a condenser).

Therefore, there is a need for a heat exchanger assembly which overcomes or reduces at least some of the above-described drawbacks.

CN 1782601 A discloses an air conditioner according to the preamble of claim 1, including: a casing with an air inlet port and an air outlet port; a blower set inside the casing to convey air to inside and outside of the casing; heat exchangers arranged between the air inlet port and the air outlet port; and guide device disposed between the heat exchangers to disperse air towards the heat exchangers. The guide device more evenly distributes the heat exchange effect between air and refrigerant at the heat exchangers to raise the heat exchange efficiency of the heat exchangers.

CN 104654825 A discloses a flow guide device for an air-cooled unit with Delta-shaped passage spaces. The air-cooled unit comprises a steam distribution pipe, downwards-inclined air-cooled finned tube bundles connected with the two sides of the steam distribution pipe respectively, condensate water pipes connected with the lower ends of the air-cooled finned tube bundles and an air-cooled fan arranged below the air-cooled finned tube bundles, wherein the air-cooled fan is fixedly arranged below the air-cooled finned tube bundles through an air-cooled fan frame; the steam distribution pipe, the air-cooled finned tube bundles, the condensate water pipes and the air-cooled fan enclose the Delta-shaped passage space. The flow guide device comprises a top flow guide mechanism arranged on the middle part of the Delta-shaped passage space and a bottom flow guide mechanism arranged at the bottom of the Delta-shaped passage space.

US 2017/0292789 A1 discloses an improved heat exchanger unit that includes a frame having a top region, a bottom region, and a plurality of side regions. The unit has a first cooler coupled with the frame proximate to a respective side region and generally parallel to a vertical axis. The unit has a second cooler coupled with the frame proximate to the top region and generally perpendicular to the vertical axis. The unit includes an inner airflow region within the heat exchanger unit, and a first baffle disposed within the inner airflow region.

### SUMMARY

It is an object of the present technology to ameliorate at least some of the inconveniences present in the prior art.

According to the present invention, there is provided a heat exchanger assembly. The heat exchanger assembly includes: a frame; a heat exchanger panel mounted to the frame and configured to exchange heat with air flowing therethrough, the heat exchanger panel having a lower end and an upper end, the heat exchanger panel being disposed at an inclined orientation such that the upper and lower ends thereof are offset from one another, the heat exchanger panel comprising: a tubing arrangement for circulating fluid therein; and a plurality of fins in thermal contact with the tubing arrangement, the fins being spaced apart from one another for air to flow therebetween and into an interior space of the heat exchanger assembly; a plurality of enclosing panels connected to the frame and defining in part the interior space of the heat exchanger assembly; a fan assembly disposed vertically above the heat exchanger panel, the fan assembly comprising a fan impeller rotatable about a fan rotation axis to pull air into the interior space of the heat exchanger assembly through the heat exchanger panel and evacuate heated air upwardly from the interior space of the heat exchanger assembly through the fan assembly; and a sound dampening device disposed within the interior space of the heat exchanger assembly such that air is pulled into the interior space through the heat exchanger panel and then flows through the sound dampening device before being discharged from the heat exchanger assembly via the fan assembly, the sound dampening device comprising: a plurality of baffle members, the baffle members being spaced apart from one another for allowing air flow therebetween, each of the baffle members extending at an angle relative to a plane extending through the upper and lower ends of the heat exchanger panel so as to direct air flow upwardly toward the fan assembly.

In some embodiments, each of the baffle members has a first portion and a second portion extending from the first portion; the first portion is positioned closer to the heat exchanger panel than the second portion such that air pulled into the heat exchanger assembly and flowing through the sound dampening device traverses along the first portion of each of the baffle members before reaching the second portion thereof; and the second portion extends upwardly at an angle relative to the first portion to deflect air flow incoming from a direction of the first portion.

In some embodiments, the second portion of each baffle member extends generally vertically.

In some embodiments, the first portion of each baffle member extends at an angle between 40° and 75° inclusively relative to a horizontal plane.

In some embodiments, a spacing between consecutive ones of the baffle members is variable.

In some embodiments, each of the baffle members has an upper end and a lower end; and the lower end of a given one of the baffle members is positioned vertically lower than the upper end of a consecutive one of the baffle members positioned below the given one of the baffle members.

In some embodiments, the baffle members are first baffle members; the sound dampening device further comprises: a plurality of second baffle members affixed to the first baffle members, the second baffle members extending perpendicular to the first baffle members and to the plane extending through the upper and lower ends of the heat exchanger panel, the second baffle members being spaced apart from one another, the first baffle members and the second baffle members forming air ducts therebetween.

In some embodiments, the first baffle members and the second baffle members form a rectangular grid defining the air ducts.

In some embodiments, each of the second baffle members has a generally triangular shape.

In some embodiments, each of the second baffle members comprises: a first edge; a second edge extending perpendicularly to the first edge; and a third edge extending diagonally relative to the first and second edges, the third edge being adjacent to the heat exchanger panel.

In some embodiments, a spacing between consecutive ones of the second baffle members is variable.

In some embodiments, the heat exchanger assembly further comprises: a plurality of acoustic panels connected to the enclosing panels for acoustically insulating the interior space of the heat exchanger assembly.

In some embodiments, the heat exchanger panel is a first heat exchanger panel; the fan assembly is a first fan assembly, and the fan rotation axis is a first fan rotation axis; the sound dampening device is a first sound dampening device; and the heat exchanger assembly further comprises: a second heat exchanger panel mounted to the frame and configured to exchange heat with air flowing therethrough, the second heat exchanger panel having a lower end and an upper end, the second heat exchanger panel being disposed at an inclined orientation such that the upper and lower ends thereof are offset from one another, the first and second heat exchanger panels being disposed in a V-configuration such that a distance between the upper ends of the first and second heat exchanger panels is greater than a distance between the lower ends of the first and second heat exchanger panels, the second heat exchanger panel comprising: a tubing arrangement for circulating fluid therein; and a plurality of fins in thermal contact with the tubing arrangement of the second heat exchanger panel, the fins of the second heat exchanger panel being spaced apart from one another for air to flow therebetween and into the interior space of the heat exchanger assembly; a second fan assembly disposed vertically above the second heat exchanger panel, the second fan assembly comprising: a fan impeller rotatable about a second fan rotation axis to pull air into the interior space of the heat exchanger assembly through the second heat exchanger panel and evacuate heated air upwardly from the interior space of the heat exchanger assembly through the second fan assembly; and a second sound dampening device disposed within the interior space of the heat exchanger assembly such that air is pulled into the interior space through the second heat exchanger panel and then flows through the second sound dampening device before being discharged from the heat exchanger assembly via the second fan assembly, the second sound dampening device comprising: a plurality of baffle members comprising a sound absorbing material, the baffler members of the second sound dampening device being spaced apart from one another for allowing air flow therebetween, each of the baffle members of the second sound dampening device extending at an angle relative to a plane extending through the upper and lower ends of the second heat exchanger panel so as to direct air flow upwardly toward the second fan assembly.

In some embodiments, the frame includes: a first leg and a second leg laterally spaced apart from the first leg; at least one lower transversal member extending laterally and interconnecting the first and second legs; a first upstanding member and a second upstanding member laterally spaced apart from the first upstanding member, the first and second upstanding members extending upwardly from the first and second legs; an upper transversal member extending laterally and connected to upper ends of the first and second upstanding members; and an upper frame assembly affixed to the upper transversal member and supporting the first and second fan assemblies, wherein: the first and second heat exchanger panels are disposed on opposite sides of a vertical plane extending through the first and second upstanding members; and the first fan rotation axis and the second fan rotation axis are disposed on opposite sides of the vertical plane extending through the first and second upstanding members.

In some embodiments, the sound absorbing material is one of: a foam material, fiberglass, mineral wool and cotton.

Embodiments of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of embodiments of the present technology will become apparent from the following description, the accompanying drawings and the appended claims.

### BRIEF DESCRIPTION OF DRAWINGS

Further aspects and advantages of the present technology will become better understood with reference to the description in association with the following in which:
FIG. 1 is a perspective view of a heat exchanger assembly according to an embodiment of the present technology;
FIG. 2 is a front elevation view of the heat exchanger assembly of FIG. 1;
FIG. 3 is a top plan view of the heat exchanger assembly of FIG. 1;
FIG. 4 is a side elevation view of the heat exchanger assembly of FIG. 1;
FIG. 5 is a perspective view of a frame and heat exchanger panels of the heat exchanger assembly of FIG. 1;
FIG. 6 is a perspective view of part of the frame and heat exchanger panels of the heat exchanger assembly of FIG. 1;
FIG. 7 is a perspective view of part of the frame of the heat exchanger assembly of assembly FIG. 1;
FIG. 8 is perspective view of a casing of the heat exchanger assembly of FIG. 1;
FIG. 9 is a top plan view of the casing of FIG. 8;
FIG. 10 is a side elevation view of the casing of FIG. 8;
FIG. 11 is a perspective view of a cross-section of the casing of FIG. 8 taken along line 11-11 in FIG. 8;
FIG. 12 is a cross-sectional view of the casing of FIG. 8 taken along line 12-12 in FIG. 10;
FIG. 13 is an exploded view of the casing of FIG. 8;
FIG. 14 is a perspective view of the heat exchanger assembly of FIG. 1 with fan assemblies thereof removed;
FIG. 15 is a cross-sectional view of the heat exchanger assembly of FIG. 1 taken along line 15-15 in FIG. 3;
FIG. 16 is a part of the cross-sectional view of FIG. 11 shown in greater detail;
FIG. 17 is a side elevation view of a conventional dry cooler according to the prior art;
FIG. 18 is a cross-sectional view of part of the conventional dry cooler of FIG. 17; and
FIG. 19 is a perspective view of part of the heat exchanger assembly in accordance with another embodiment in which the heat exchanger assembly has sound dampening devices disposed in an interior space of the heat exchanger assembly, the heat exchanger panels being removed to expose the sound dampening devices;
FIG. 20 is a front elevation view of the part of the heat exchanger assembly of FIG. 19;
FIG. 21 is a side elevation view of the heat exchanger assembly of FIG. 19, with side enclosing panels thereof removed to expose the sound dampening devices;
FIG. 22 is a top plan view of the heat exchanger assembly of FIG. 19, with fan assemblies thereof removed to expose the sound dampening devices;
FIG. 23 is a perspective view of a baffle member of one of the sound dampening devices of FIG. 19;
FIG. 24 is a perspective view of part of the heat exchanger assembly provided with sound dampening devices in accordance with another embodiment, the heat exchanger panels and some side enclosing panels being removed to expose the sound dampening devices;
FIG. 25 is a front elevation view of the part of the heat exchanger assembly of FIG. 24;
FIG. 26 is a side elevation view of the heat exchanger assembly of FIG. 24, with side enclosing panels thereof removed to expose the sound dampening devices;
FIG. 27 is a side elevation of one of the sound dampening devices of FIG. 24;
FIG. 28 is a perspective view of a baffle member of the sound dampening device of FIG. 27;
FIG. 29 is a perspective view of part of the heat exchanger assembly provided with sound dampening devices in accordance with another embodiment, the heat exchanger panels and some side enclosing panels being removed to expose the sound dampening devices;
FIG. 30 is a front elevation view of the part of the heat exchanger assembly of FIG. 29;
FIG. 31 is a side elevation view of the heat exchanger assembly of FIG. 29, with side enclosing panels thereof removed to expose the sound dampening devices;
FIG. 32 is a side elevation of one of the sound dampening devices of FIG. 29;
FIG 33 is a perspective view of a baffle member of the sound dampening device of FIG. 32;
FIG. 34 is a perspective view of part of the heat exchanger assembly provided with sound dampening devices in accordance with another embodiment, the heat exchanger panels and some side enclosing panels being removed to expose the sound dampening devices;
FIG. 35 is a front elevation view of the part of the heat exchanger assembly of FIG. 34;
FIG. 36 is a side elevation view of the heat exchanger assembly of FIG. 34, with side enclosing panels thereof removed to expose the sound dampening devices;
FIG. 37 is a perspective view of one of the sound dampening devices of FIG. 34;
FIG. 38 is a top plan view of the sound dampening device of FIG. 37;
FIG. 39 is a side elevation view of the sound dampening device of FIG. 37;
FIG. 40 is a perspective view of part of the heat exchanger assembly provided with sound dampening devices in accordance with another embodiment, the heat exchanger panels and some side enclosing panels being removed to expose the sound dampening devices;
FIG. 41 is a front elevation view of the part of the heat exchanger assembly of FIG. 40;
FIG. 42 is a side elevation view of the heat exchanger assembly of FIG. 40, with side enclosing panels thereof removed to expose the sound dampening devices;
FIG. 43 is a perspective view of one of the sound dampening devices of FIG. 40;
FIG. 44 is a top plan view of the sound dampening device of FIG. 43;
FIG. 45 is a side elevation view of the sound dampening device of FIG. 43;
FIG. 46 is a cross-sectional view of part of a baffle member of the sound dampening device of FIG. 24; and
FIG. 47 is a perspective view of part of the heat exchanger assembly, showing acoustic panels thereof connected to the enclosing panels of the heat exchanger assembly.

### DETAILED DESCRIPTION

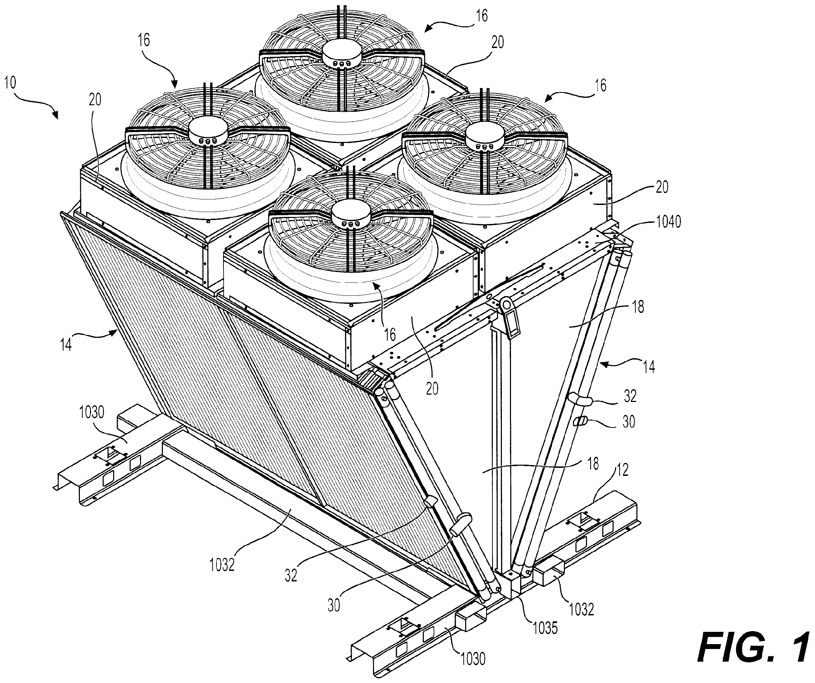

As seen in FIG. 1, there is provided a heat exchanger assembly 10 in accordance with an embodiment of the present technology. In this embodiment, the heat exchanger assembly 10 is a dry cooler 10. However, it is contemplated that any other suitable type of heat exchanger assembly (e.g., a condenser, a chiller) may be constructed in the manner that will be described below.

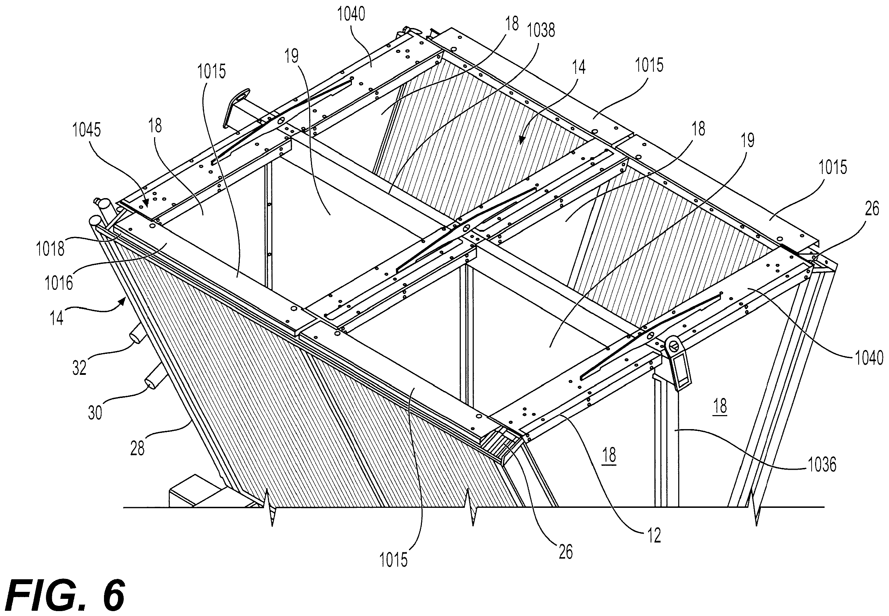

The dry cooler 10 comprises a frame 12 which supports the dry cooler 10 on a support surface (e.g., a roof of a building), a plurality of heat exchanger panels 14 for exchanging heat with air flowing therethrough, and a plurality of fan assemblies 16 for pulling air through the heat exchanger panels 14 and discharging air from an interior space 25 of the dry cooler 10. A plurality of enclosing panels 18, 19 (FIG. 6) are also affixed to the frame 12 to define in part the interior space 25 of the dry cooler 10.

As will be described in greater detail below, the dry cooler 10 is also provided with casings 20 (each one associated with a respective one of the fan assemblies 16) to attenuate sound emissions generated by the dry cooler 10.

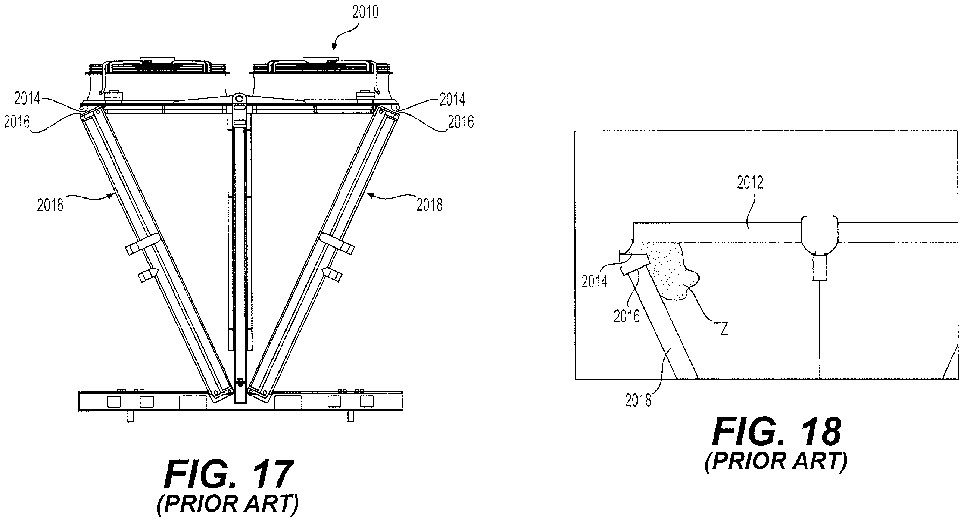

Notably, with reference to FIGs. 17 and 18, a significant source of sound emission in a conventional dry cooler 2010 has been found to be caused by a "blade-passing effect" which involves part of a fan impeller 2012 of the dry cooler 2010 passing over a plate member 2014 disposed atop an upper end 2016 of a heat exchanger panel 2018. In particular, with reference to FIG. 18 which illustrates a cross-section of the conventional dry cooler 2010, a fluid flow analysis has shown that the proximity of the fan impeller 2012 to the plate member 2014 causes the flow of air within the dry cooler 2012 to be turbulent at zone TZ between the fan impeller 2012 and the plate member 2014. This turbulent flow has been identified as a significant source of noise produced by the conventional dry cooler 2010, in addition to generating significant vibrations which can negatively affect the life cycle of certain components of the dry cooler 2010. It should be pointed out that the blade-passing effect is in part a result of a desire to produce a narrower dry cooler 2010 (which makes it easier to transport and affords more space in the environment in which it is installed) while simultaneously having a fan impeller 2012 of a significant diameter to improve the efficiency of the dry cooler 2010. As will be described below, the casings 20 of the dry cooler 10 alleviate this blade-passing effect such that the dry cooler 10 is relatively quiet in comparison to the conventional dry cooler 2010.

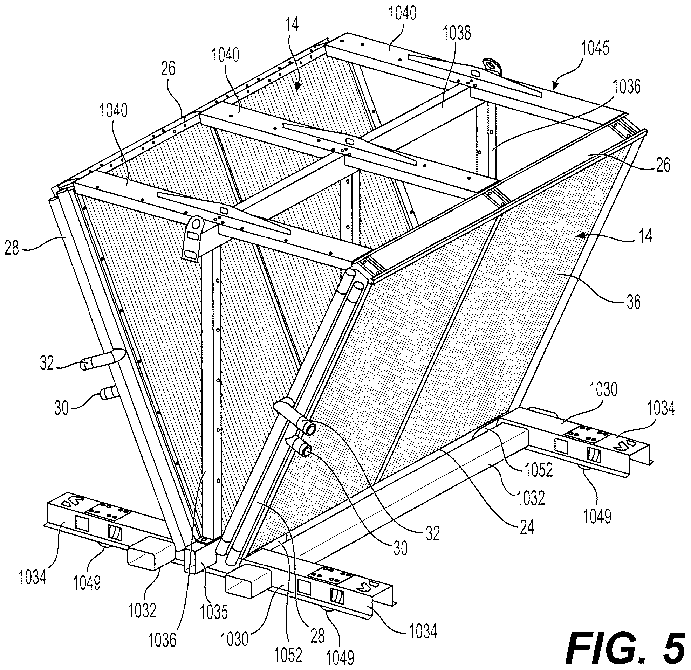

Returning now to the dry cooler 10 of the present technology, with reference to FIGs. 5 to 7, the frame 12 is configured to support various components of the dry cooler 10. To that end, the frame 12 comprises two legs 1030 laterally spaced apart from one another and which support the dry cooler 10 on the support surface. Each of the legs 1030 extends from a first end to a second end and has opposite end portions 1034 and a central portion 1037 between the end portions 1034. In this embodiment, the end portions 1034 of each of the legs have a U-shaped cross-section while the central portion 1037 has a generally planar configuration forming a wall that extends along a plane extending vertically and parallel to the legs 1030. In some embodiments, the dry cooler 10 may include wheels 1049 (e.g., caster wheels) (FIG. 5) that are connected to the end portions 1034 of the legs 1030 such that the dry cooler 10 can be more easily displaced. For instance, this may facilitate moving the dry cooler 10 in/out of a container for transport.

Interconnecting the legs 1030 is a lower transversal member 1035 which extends laterally (i.e., transversally to the legs 1030) and interconnects the legs 1030 of the frame 12. In this embodiment, the lower transversal member 1035 is centered between the ends of each of the legs 1035 and is thus connected to the central portion 1037 of each of the legs 1030. More specifically, in this example, each of the legs 1030 has a cut-out configured to support therein part of the lower transversal member 1035. To that end, the cut-out has a shape and dimensions designed to receive the lower transversal member 1035.

A pair of bracing members 1032 also extend laterally (i.e., parallel to and spaced apart from the lower transversal member) to interconnect the legs 1030. More specifically, the end portions 1034 of each of the legs 1030 have a rectangular groove for receiving a respective one of the bracing members 1032. The bracing members 1032 may be connected to the legs 1030 in any suitable way. In this example, the bracing members 1032 are fastened (e.g., welded) to the legs. The bracing members 1032 are positioned such that the lower transversal member 1035 is disposed between the bracing members 1032. The bracing members 1032 may be used to lift the dry cooler 10 via a forklift or other work vehicle, with the forks thereof being engaged within the cavity of each of the bracing members.

A plurality of angular members 1052 are located between the legs 1030 and are configured to support the heat exchanger panels 14 of the dry cooler 10. In this embodiment, four angular members 1052 are provided, with each angular member 1052 being disposed between a respective one of the bracing members 1032 and the lower transversal member 1035 such that two of the angular members 1052 are located on one side of the lower transversal member 1035 while the other two angular members 1052 are located on the opposite side of the lower transversal member1035. Moreover, in this embodiment, each of the angular members 1052 is connected to a respective one of the legs 1030 and to the lower transversal member 1035. It is contemplated that, in alternative embodiments, the angular members 1052 could be connected solely to the lower transversal member 1035. The angular members 1052 have an angular configuration for conforming to the orientation of lower ends 24 of the heat exchanger panels 14. Notably, each angular member 1052 includes two upwardly oriented faces that are transversal (e.g., perpendicular) to one another and converge at a junction. In this embodiment, the angular member is a bent component such that the junction is a bend in the angular member.

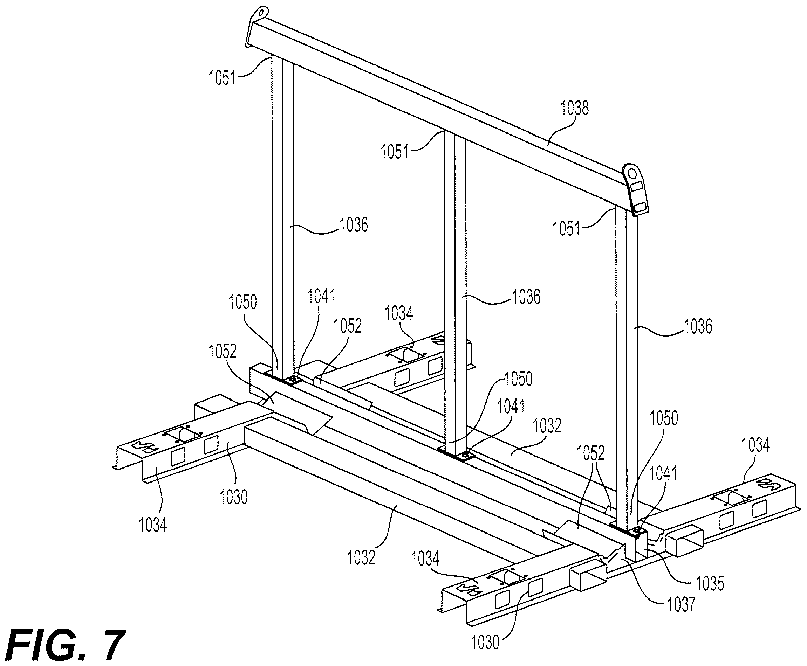

The frame 12 further comprises three upstanding members 1036 laterally spaced apart from one another and extending upwardly (e.g., vertically) from the lower transversal member 1035. Notably, each of the upstanding members 1036 extends from a lower end portion 1050 that is connected to the lower transversal member 1050 to an upper end portion 1051. The upstanding members 1036 can be connected to the lower transversal member 1035 in any suitable way. In this embodiment, as shown in FIG. 7, fasteners (e.g., bolts) fasten a flange 141 at the lower end portion 1050 of each of the upstanding members 1036 to the lower transversal member 1035. An upper transversal member 1038, extending laterally and connecting the upper end portions 1051 of the upstanding members1036, is disposed above the lower transversal member 1035. The upper transversal member 1038 is connected to the upstanding members 1036 in any suitable way (e.g., welded).

An upper frame assembly 1045 is affixed to the upper transversal member 1038 and is configured to support the casings 20. The upper frame assembly 1045 comprises three upper retaining members 1040 which extend transversally to the upper transversal member 1038 and parallel to the legs 1030. The upper retaining members 1040 are laterally spaced apart from one another and are connected to the upper transversal member 1038. More specifically, an underside of each of the upper retaining members 1040 has a cut-out of an appropriate shape and size for receiving part of the upper transversal member 1038.

In this embodiment, the lower transversal member 1035, the upstanding members 1036, the upper transversal member 1038 and the upper retaining members 1040 are tubular, defining an interior space therein. This may allow the frame to support a greater load than if the members were made of sheet metal as is typically the case in conventional dry cooler assemblies.

As best seen in FIG. 5, the heat exchanger panels 14 are mounted to the frame 12 and configured to exchange heat with air flowing therethrough. In this embodiment, the dry cooler 10 includes two heat exchanger panels 14, each being disposed on opposite sides of a vertical plane extending through the upstanding members 1036 of the frame 12, such that the heat exchanger panels 14 are arranged on each side of the lower transversal member 1035 of the frame 12. The lower end 24 of each heat exchanger panel 14 is supported by a respective one of the angular members 1052 of the frame 12 while an upper end 26 of each heat exchanger panel 14 is affixed to the upper frame assembly 1045. In particular, the upper end 26 of each of the heat exchanger panels 14 is connected to the ends of upper retaining members 1040 via fasteners (e.g., bolts). Moreover, the lower end 24 of each of the heat exchanger panels 14 is supported by at least one of the angular members 1052 of the frame 12 such that the lower end 24 of each of the heat exchanger panels 14 is disposed between the bracing members 1032 of the frame 12. The lower end 24 of each of the heat exchanger panels 14 is fastened (e.g., bolted) to the angular members 1052.

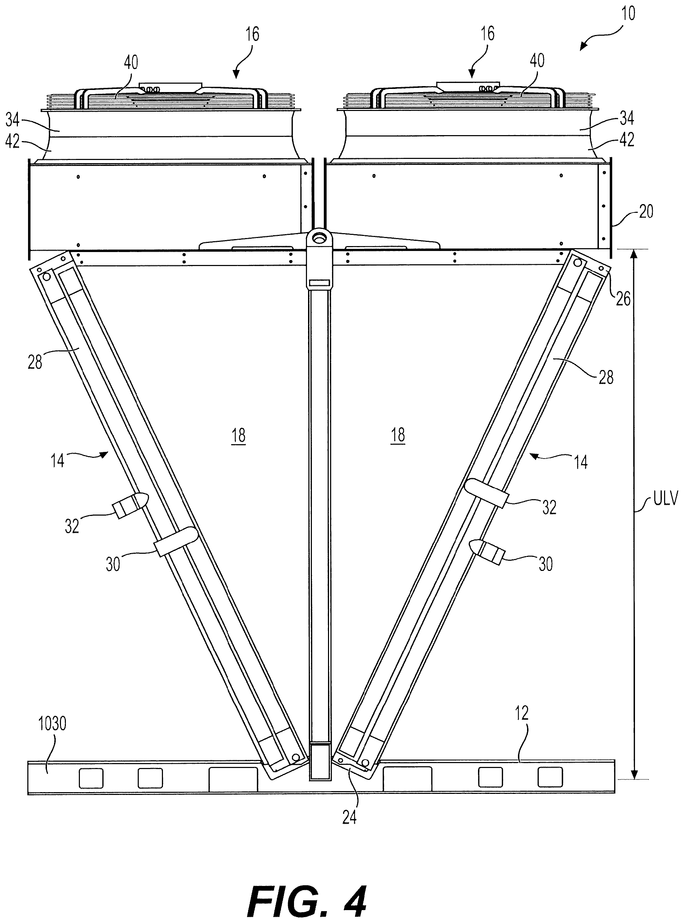

Notably, as best seen in FIG. 4, each of the heat exchanger panels 14 is disposed in an inclined orientation such that the upper and lower ends 24, 26 thereof are offset from one another. In particular, the two heat exchanger panels 14 are disposed in a V-configuration such that a distance between the upper ends 26 of the heat exchanger panels 14 is greater than a distance between the lower ends 24 of the heat exchanger panels 14. For instance, an angle formed between the heat exchanger panels 14 may be approximately 50°. This configuration reduces the footprint, or amount of ground space occupied by the dry cooler 10 and facilitates its transport, notably in shipping containers, or heavy-duty trailers, and the like.

Moreover, as shown in FIG. 6, four outer fan supporting members 1015 are connected to respective ones of the heat exchanger panels 14 and are configured to support respective ones of the fan assemblies 16. In particular, the outer fan supporting members 1015 are provided to support an outer part of a corresponding one of the fan assemblies 16 due to a significant diameter of a fan impeller thereof which extends beyond the innermost point of an upper end 26 of the corresponding heat exchanger panel 14. As such, each of the outer fan supporting members 1015 is disposed vertically above the upper end 26 of one of the heat exchanger panels 14. Notably, the upper end 26 of each heat exchanger panel 14 is disposed vertically below two of the outer fan supporting members 1015. Each outer fan supporting member 1015 is generally elongated and extends laterally (i.e., parallel to the upper transversal member 1038). Each outer fan supporting member 1015 has a flat plate portion 1016 and two lip portions 1018 (only one of which is shown in the Figures) extending downwardly and perpendicularly from the flat plate portion 1016. Both the flat plate portion 1016 and the lip portions 1018 extend along an entire length of the outer fan supporting member 1015. The flat plate portion 1016 is configured for affixing the corresponding fan assembly 16 thereto. Notably, the flat plate portion 1016 is provided with openings for receiving corresponding fasteners therein to affix the fan assembly 16 to the flat plate portion 1016. The innermost lip portion 1018 is affixed to the upper end 26 of the corresponding heat exchanger panel 14.

It is to be understood that the expression "vertically above" used herein to describe the positioning of components refers to a component being vertically higher than another component while simultaneously being at least partly laterally and longitudinally aligned with that component. Similarly, the expression "vertically below" used herein refers to a component being vertically lower than another component while simultaneously being at least partly laterally and longitudinally aligned with that component.

It is contemplated that, in other embodiments, two outer fan supporting members 1015 may be provided instead of four, with each outer fan supporting member 1015 extending above the upper end 26 of one of the heat exchanger panels 14.

As both heat exchanger panels 14 are configured identically in this embodiment, only one of the heat exchanger panels 14 will be described in detail below. It is understood that the same description applies to the other heat exchanger panel 14.

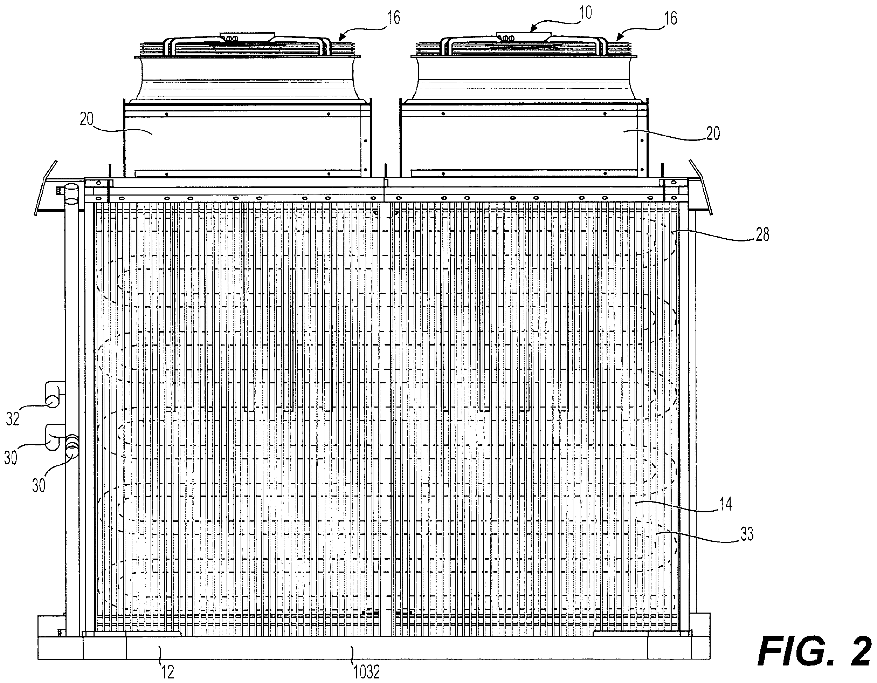

The heat exchanger panel 14 comprises a tubing arrangement 28 for circulating fluid therein, best seen in FIG. 2. In this embodiment, the fluid circulated in the tubing arrangement 28 is water; however, it is contemplated that other fluids or additional fluids (e.g., glycol) could circulate within the tubing arrangement 28 as well. The fluid enters the tubing arrangement 28 through a fluid intake 30, and exits the tubing arrangement through a fluid outtake 32. As air is pulled into the dry cooler 10 through the heat exchanger panel 14, heat is transferred from water circulating in the tubing arrangement 28 to the air being pulled into the dry cooler10. As such, the water circulating in the tubing arrangement 28 is cooled while, conversely, the air pulled into the dry cooler 10 is heated.

As best seen in FIG. 2, the heat exchanger panel 14 also comprises a plurality of fins 33 in thermal contact with the tubing arrangement 28 to facilitate heat exchange between fluid circulating in the tubing arrangement 28 and air pulled into the dry cooler 10. The fins 33 are spaced apart from one another for air to flow therebetween and into the interior space 25 of the dry cooler 10.

In alternative embodiments, each heat exchanger panel 14 may be replaced by a plurality of heat exchanger panels (e.g., two heat exchanger panels) arranged to be laterally-adjacent to one another (i.e., disposed side-by-side) to form a series of laterally-adjacent heat exchanger panels. In such embodiments, each series of laterally-adjacent heat exchanger panels would thus be disposed on opposite sides of the vertical plane extending through the upstanding members 1036 of the frame 12.

As shown in FIGs. 1, 4 and 6, the enclosing panels 18, 19 are connected to the frame 12 and define in part the interior space 25 of the dry cooler 10. More specifically, the enclosing panels 18, 19 define in part the lateral outer boundaries of the interior space 25 of the dry cooler 10 and also sub-divide the interior space 25 into sub-compartments, each sub-compartment being associated with a respective one of the fan assemblies 16. The enclosing panels 18, 19 include side enclosing panels 18 and middle enclosing panels 19 which extend perpendicularly to one another. Notably, the side enclosing panels 18 generally extend along a longitudinal plane (extending parallel to the legs 1030 of the frame 12) while the middle enclosing panels 19 generally extend along a lateral plane perpendicular to the longitudinal plane. In this embodiment, the dry cooler 10 includes six side enclosing panels 18 and two middle enclosing panels 19.

Each of the side enclosing panels 18is connected to a respective one of the upstanding members 1036 of the frame 12, to an adjacent portion of an upper retaining member 1040, and to a respective one of the heat exchanger panels 14. As such, each upstanding member 1036 of the frame 12 is connected to two of the side enclosing panels 18. The side enclosing panels 18 which are disposed at the lateral extremities of the dry cooler 10 define outer walls of the dry cooler 10. On the other hand, the side enclosing panels 18 which are disposed between the lateral extremities of the dry cooler 10, namely between laterally-adjacent ones of the fan assemblies 16, define inner walls of the dry cooler 10 that sub-divide the interior space of the dry cooler 10 into laterally-adjacent sub-compartments. Given the inclined orientation of the heat exchanger panels 14, in this embodiment, the side enclosing panels 18 are generally triangular in shape.

Each of the middle enclosing panels 19 is connected to adjacent ones of the upstanding members 1036 of the frame 12, to an adjacent portion of the upper transversal member 1038 and to the lower transversal member 1035. The middle enclosing panels 19 thus define inner walls of the dry cooler 10 that sub-divide the interior space 25 of the dry cooler 10 into longitudinally-adjacent sub-compartments. Therefore, together, the middle enclosing panels 19 and the side enclosing panels 18 which are disposed between the lateral extremities of the dry cooler 10 define the inner walls of the dry cooler 10 which sub-divide the interior space 25 of the dry cooler 10, and together with the other side enclosing panels 18 allow for each fan assembly 16 to have an isolated volume within which to pull air into and evacuate air therefrom. In this embodiment, the middle enclosing panels 19 are generally rectangular.

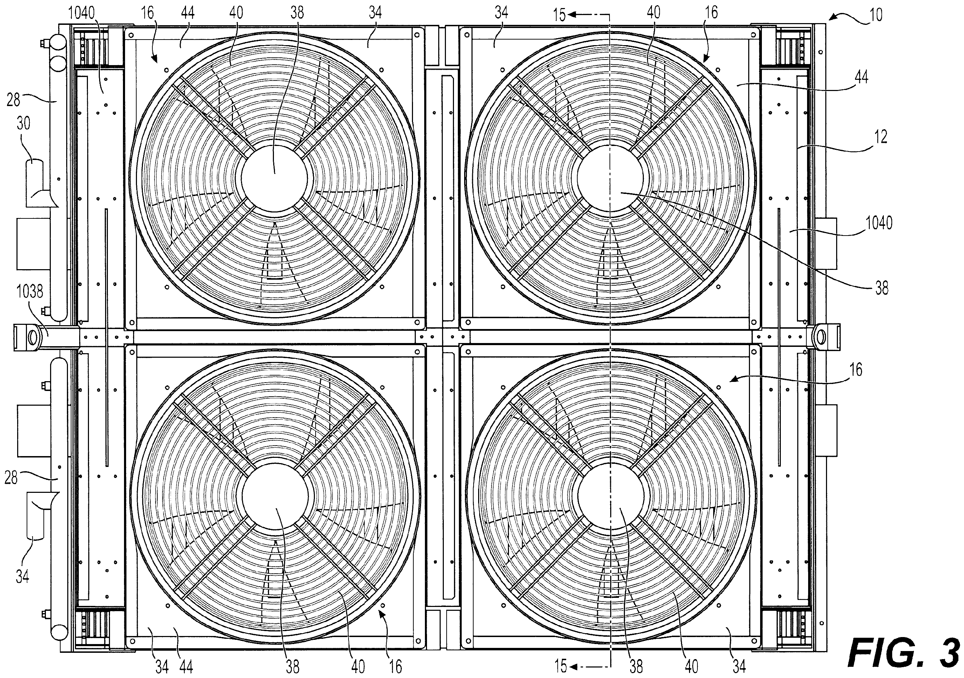

With reference to FIGs. 1 to 4, the fan assemblies 16 are disposed above and mounted to the casings 20 such that the casings 20 are disposed between the fan assemblies 16 and the upper ends 26 of the heat exchanger panels 14. As each fan assembly 16 is configured identically in this embodiment, only one of the fan assemblies 16 will be described in detail herein. It is understood that the same description applies to the other fan assemblies 16.

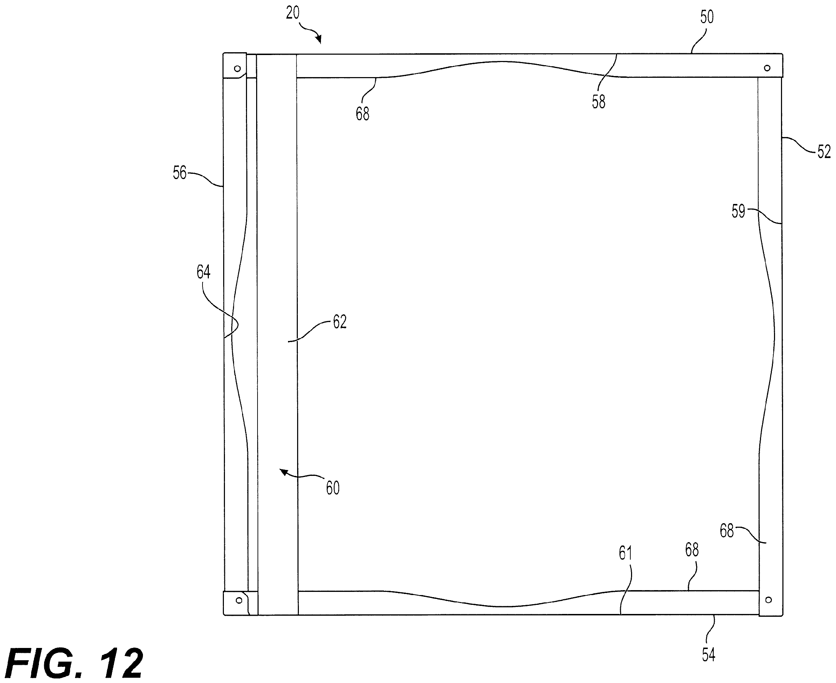

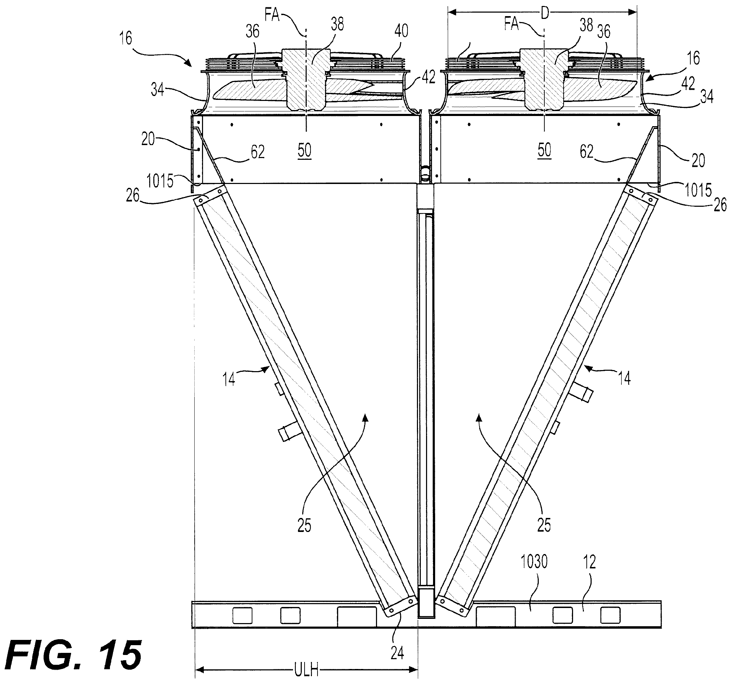

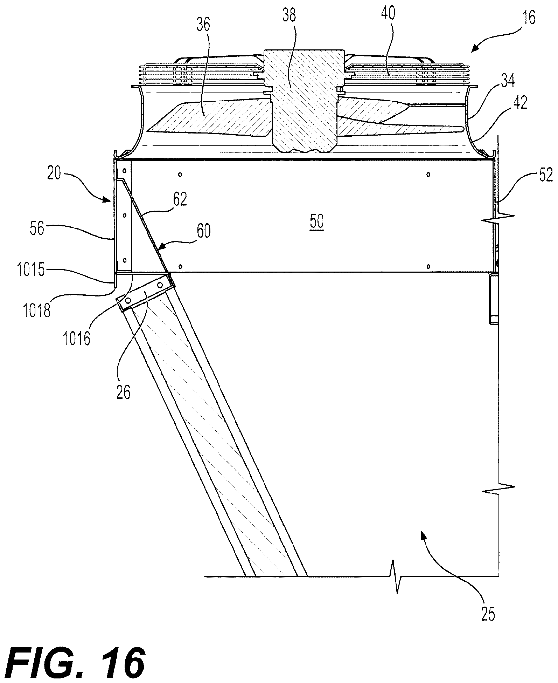

The fan assembly 16 comprises a fan mount 34 and a fan impeller 36 connected thereto (shown in FIGs. 15, 16). The fan mount 34 has an outer flange portion 44 and an annular portion 42 extending upwardly from the outer flange portion 44. The outer flange portion 44 of the fan mount 34 is connected to an upper end 47 of the corresponding casing 20, while the fan impeller 36 connects to the fan mount 34 via a motor 38 (FIG. 12) that is supported by the annular portion 42 of the fan mount 34. More specifically, a grill 40 covers and is affixed to the upper end of the annular portion 42 of the fan mount 34 and supports the motor 38 centrally thereof. The fan impeller 36 is rotatable by the motor 38 about a fan rotation axis FA extending generally vertically (i.e., parallel to the upstanding members 1036 of the frame 12).

The fan impeller 36 is of a significant size to provide the dry cooler 10 with efficient performance. For instance, in this embodiment, the fan impeller 36 has a diameter D of 950 mm. Given its significant size, the fan impeller 36 is sized and positioned such that part of the fan impeller 36 rotates vertically above the upper end 26 of a corresponding one of the heat exchanger panels 14. The fan impeller 36 is surrounded by the annular portion 42 of the fan mount 34. The fan impeller 36 may have an even greater diameter in other embodiments. For instance, in some embodiments, rather than having the middle enclosing panels 19, a larger fan impeller may be provided generally centered between the two heat exchanger panels disposed in the V-configuration.

The fan assemblies 16 are thus arranged to evacuate heated air upwardly from the interior space 25 of the dry cooler 10. Notably, in use, rotation of the fan impeller 36 of each fan assembly 16 causes ambient air to be pulled into dry cooler 10 through the corresponding heat exchanger panel 14. As air is pulled in, heat is transferred from fluid circulating in the tubing arrangement 28 of the heat exchanger panel 14 to the air, such that the air becomes heated. The heated air is then rejected upwardly from the interior space 25 of the dry cooler 10 through the fan assembly 16.

It is contemplated that, in other embodiments, rather than having two, or four fan assemblies 16 (i.e., a plurality of fan assemblies on each side of a vertical plane extending through the upstanding members 1036 of the frame 12), the dry cooler 10 may have a plurality of fan assemblies arranged laterally-adjacent to one another to form a single row of laterally-adjacent fan assemblies.

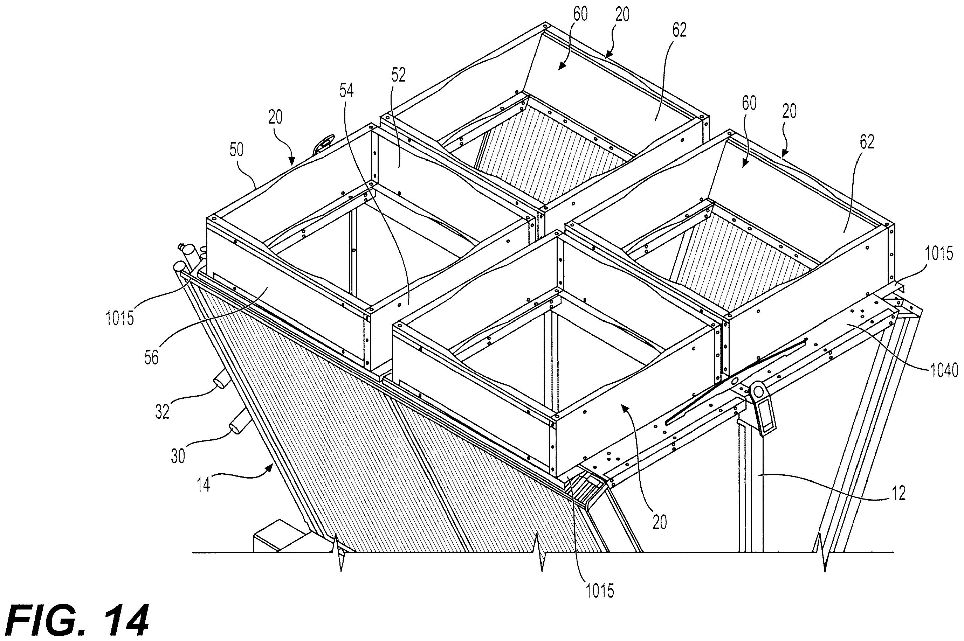

With reference to FIG. 14, the casings 20 are mounted to the upper frame assembly 1045. Specifically, each casing 20 is disposed between the upper frame assembly 1045 and a corresponding one of the fan assemblies 16. As such, each casing 20 is positioned between the corresponding fan assembly 16 and the upper end 26 of the corresponding heat exchanger panel 14, thus distancing the fan impeller from the outer fan supporting member 1015 disposed above the upper end 26 of the heat exchanger panel 14. This increased spacing between the fan impeller 36 and the outer fan supporting members 1015 results in a reduction in the turbulence and velocity of air at the area between the fan impeller and the outer fan supporting member 1015 compared to the conventional dry cooler 2010 of FIGs. 17 and 18, which in turn significantly reduces the blade-passing effect and the sound generated thereby. Furthermore, the distance created between the fan assembly 16 and the upper end 26 of the heat exchanger panel 14 allows for the installation of further means of noise reduction below the fan assembly 16 such as grids and the like, which can further reduce the blade-passing effect and sound generated by the dry cooler 10.

In this embodiment, each casing 20 is configured identically and therefore only one of the casings 20 will be described in detail herein. It is understood that the same description applies to the other casings 20.

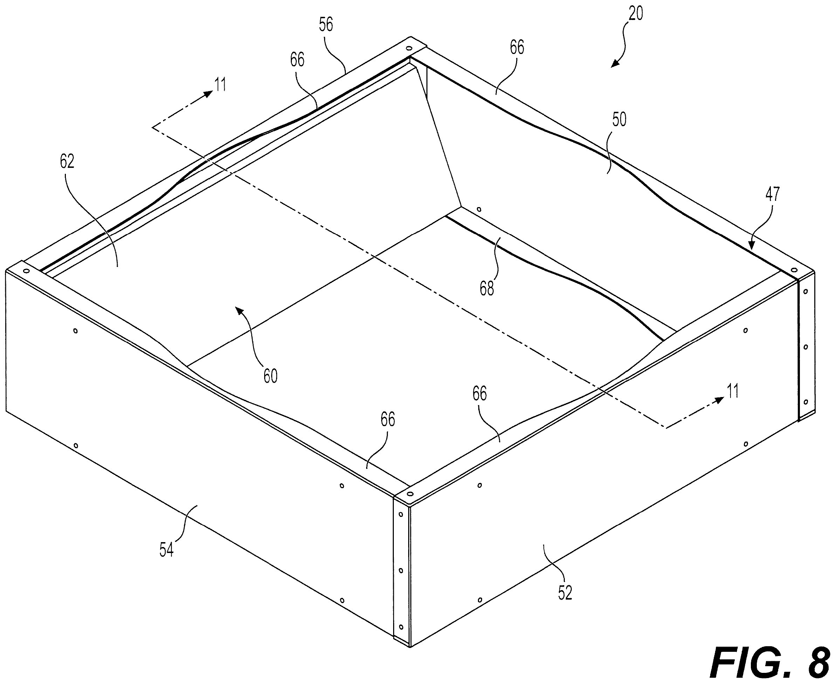

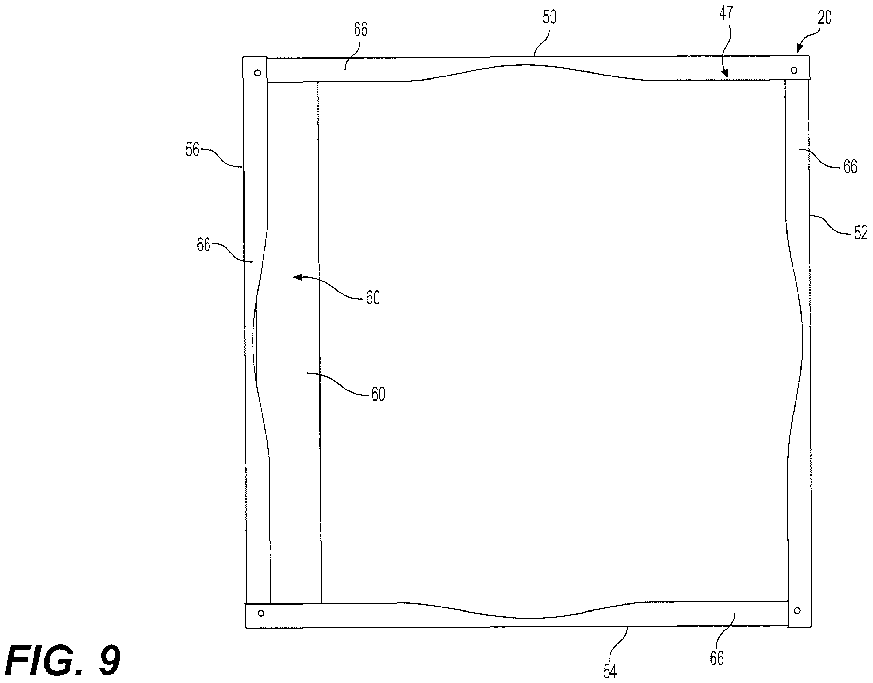

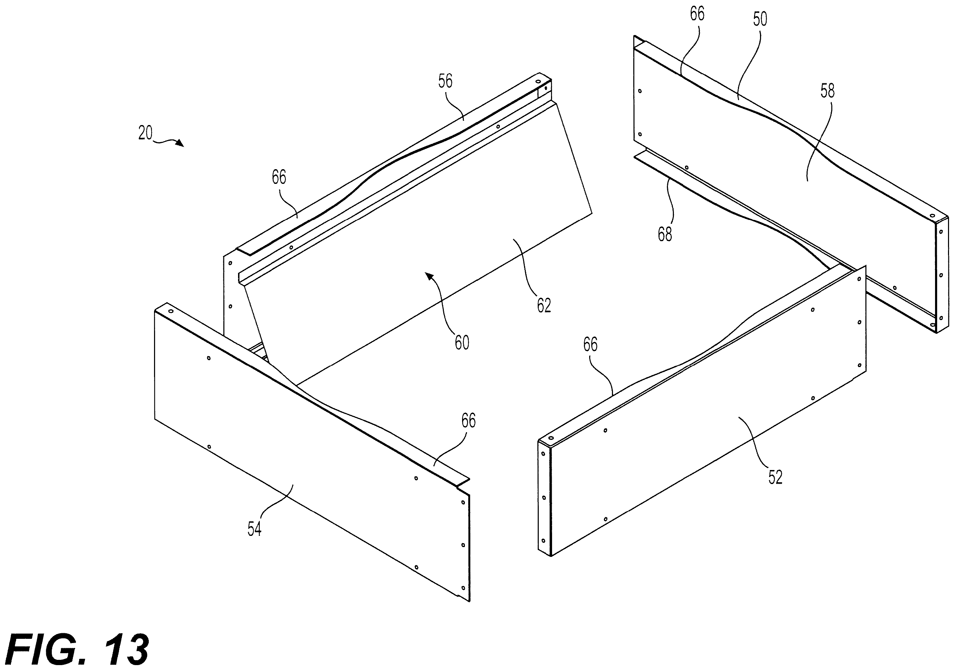

With reference to FIGs. 8 to 13, the casing 20 includes four upright wall members 50, 52, 54, 56 which define the outer walls and thus the outer shape of the casing 20. In particular, in this embodiment, the upright wall members 50, 52, 54, 56 are affixed (e.g., welded) to one another to form the generally box-like shape of the casing 20. In particular, the two upright wall members 50, 54 extend generally parallel to one another while the two upright wall members 54, 56 extend generally parallel to one another (and perpendicularly to the upright wall members 50, 54). Each of the upright wall members 50, 52, 54, 56 has an upper lip portion 66 and a lower lip portion 68, and a central portion extending therebetween. The upper and lower lip portions 66, 68 of each of the upright wall member members 50, 52, 54, 56 extend perpendicularly to the central portion. The upper lip portions 66 of the upright wall members 50, 52, 54, 56 define an upper end 47 of the casing 20. Similarly, the lower lip portions 68 of the upright wall members 50, 52, 54, 56 define a lower end 49 of the casing 20. The upper end 47 thus accommodates the fan mount 34 of the fan assembly 16 so as to secure the fan mount 34 (e.g., via fasteners) to the upper end 47, while the lower end 49 is disposed atop the upper frame assembly 1045 (atop the corresponding outer fan supporting member 1015 and two of the upper retaining members 1040) and secured thereto.

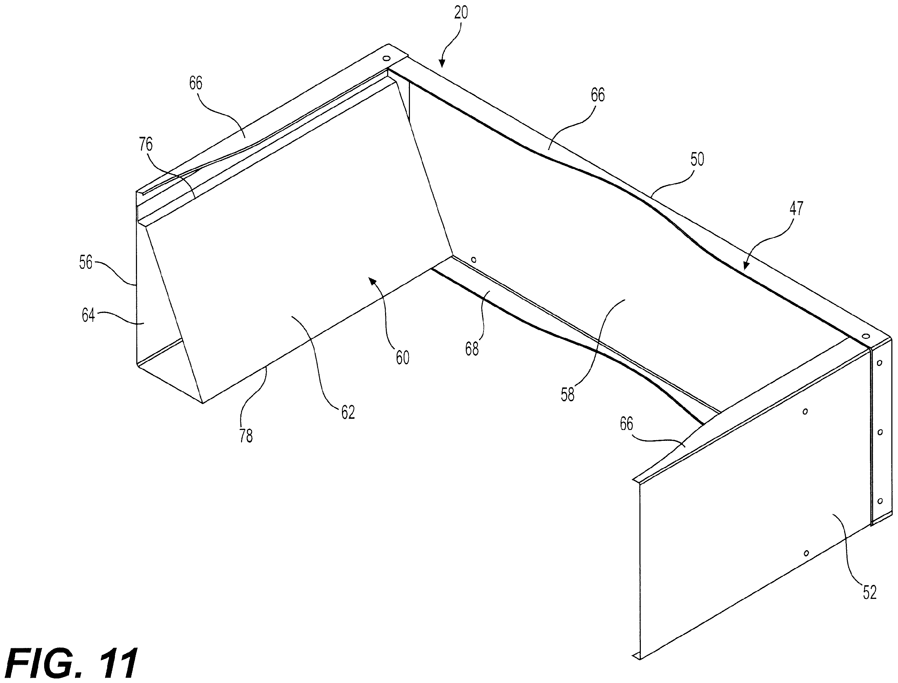

As will be understood, the casing 20 is open from its upper end 47 and its lower end 49 so as to allow air to flow from the corresponding heat exchanger panel 14 towards the corresponding fan assembly 16. Notably, the casing 20 has a plurality of inner walls for guiding air from the heat exchanger panel 14 toward the fan assembly 16. In particular, the inner walls of the casing 20 include upright inner walls 58, 59, 61 defined by the upright wall components 50, 52, 54 respectively. The upright inner walls 58, 61 are parallel to one another while the upright inner wall 59 extends transversally to the upright inner walls 58, 61. Another inner wall 62 of the casing 20 is defined by a spoiler 60 of the casing 20 which is affixed (e.g., welded) to the upright wall member 56 and thus substantially covers an inner wall 64 of the upright wall member 56 (FIG. 11). The upright inner wall 59 faces the inner wall 62. Thus, as will be understood, the inner walls 58, 59, 61 and the spoiler 60 of the casing 20 are arranged so as to define in part the interior space 25 of the dry cooler 10.

The spoiler 60 is provided to modify the dynamics of air flow between the heat exchanger panel 14 and the fan assembly 16. As shown in FIG. 11, the spoiler 60 has a lower portion 70 and a sloped portion 72 extending at angle to the lower portion 70. Notably, the lower portion 70 extends generally horizontally while the sloped portion 72 extends at an acute angle relative to the lower portion 70. The sloped portion 72 defines the inner wall 62 of the casing 20 and therefore the inner wall 62 may be referred to as a sloped wall 62. The sloped wall 62 is oriented to extend outwardly away from the fan rotation axis FA of the corresponding fan assembly 16. As such, in a given vertical plane containing the fan rotation axis and extending through the sloped wall 62, a distance between an upper end 76 of the sloped wall 62 and the fan rotation axis FA of the corresponding fan assembly 16 is greater than a distance between a lower end 78 of the sloped wall 62 and the fan rotation axis FA. As shown in FIG. 16, the sloped wall 62 is disposed adjacent to the upper end 26 of the corresponding heat exchanger panel 14 and extends generally parallel to the inclined orientation of the heat exchanger panel 14 such that part of the fan impeller 36 rotates vertically above the sloped wall 62. As such, an angle θ is formed between the sloped wall 62 of the casing 20 and a vertical plane VP extending laterally (parallel to the inner walls 59, 64). In this embodiment, as shown in FIG. 11, the angle θ between the sloped wall 62 of the casing 20 and the vertical plane VP is about 25°. The angle θ can be smaller or greater than 25° in other embodiments. For instance, in some embodiments, the angle θ may be between about 20° and about 40° inclusively, between about 20° and about 35° inclusively, or between about 20° and about 30° inclusively.

The angular orientation of the sloped wall 62 of the casing 20 has been found to further decrease the turbulent flow of air generated by the blade-passing effect. Therefore, the angular orientation of the sloped wall 62 results in an even greater reduction in sound emission by the dry cooler 10 than if the fan impeller 36 were only distanced further from the outer fan supporting member 1015. Furthermore, this decrease in turbulent flow further optimizes air flow at the entrance of the fan assembly 16 (as air enters the fan assembly 16 from the heat exchanger panel 14) and increases the overall performance of the dry cooler 10. By the same token, the life span of the fan impeller 36 is extended due to the reduced turbulent air flow compared to conventional dry coolers such as the conventional dry cooler 2010 of FIGs. 17 and 18, notably due to an accompanying reduction in vibrations.

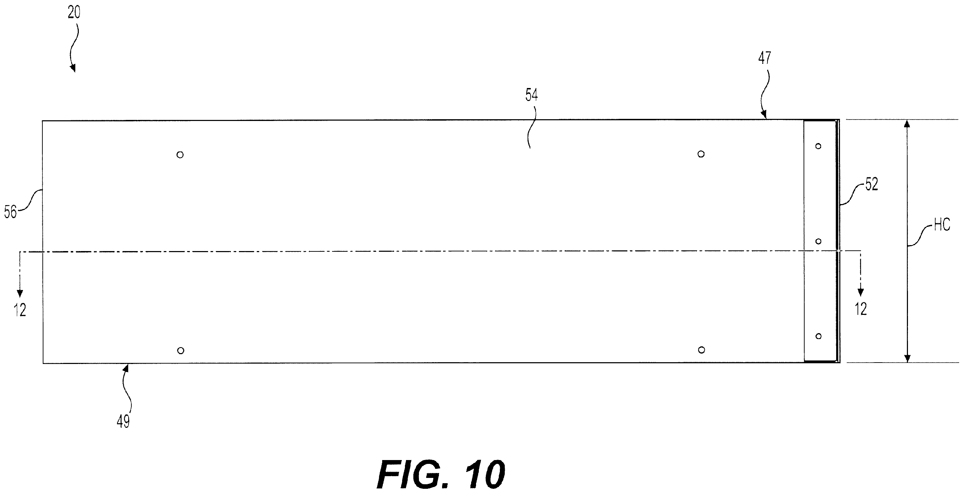

While the casing 20 reduces turbulent air flow within the interior space 25, it also increases a height of the dry cooler 10. To that end, the casing 20 is configured to elevate the corresponding fan assembly 16 sufficiently to distance the fan impeller 36 from the upper end 26 of the corresponding heat exchanger panel 14 while simultaneously avoiding having an excessively tall dry cooler 10 which would be more difficult to accommodate during transportation thereof. As such, a height HC (FIG. 10) of the casing 20, measured from the upper end 47 to the lower end 49, is significant enough for the sloped wall 62 to extend over a sufficiently long distance and thus positively affecting air flow, but not so significant as to render difficult the transport and/or the storage of the dry cooler 10. For instance, in this embodiment, a ratio of the height HC of the casing 20 over a diameter D of the fan impeller 36 (FIG. 15) is between 0.20 and 0.40. In particular, in this embodiment, the ratio of the height HC of the casing 20 over a diameter D of the fan impeller 36 is approximately 0.30 Furthermore, in this embodiment, a ratio of the height HC of the casing 20 over a vertical distance ULV (FIG. 4) between the upper and lower ends 24, 26 of the heat exchanger panel 14 is between 0.10 and 0.20. In particular, in this embodiment, the ratio of the height HC of the casing 20 over the vertical distance ULV is approximately 0.15.

For instance, in this embodiment, the height H of the casing is about 320 mm. However, it is contemplated that the height H of the casing may be between about 200 mm and 400 mm inclusively or between about 200 mm and 350 mm inclusively.

As will be understood, the provision of the casing 20 allows the installation of a bigger fan impeller 36 on the dry cooler 10 which would otherwise cause excessive turbulent air flow within the dry cooler 10 if it were not for the presence of the casing 20. As mentioned above, a bigger fan impeller 36 (i.e., having a greater diameter) improves the efficiency of the dry cooler 10 and therefore is a desirable improvement. However, the desirability of having a bigger fan impeller 36 also runs contrary to the desire of limiting the width of a dry cooler 10 to facilitate its transport (e.g., to more easily fit in a shipping container). For instance, the dry cooler 10 has a maximal width of about 2200 mm to fit in a shipping container. The casing 20 thus provides the dry cooler 10 with the possibility of having the fan impeller 36 of a significant size while also having the width of the dry cooler 10 be relatively small. For instance, in this embodiment, a ratio of the diameter D of the fan impeller 36 over a horizontal distance ULH (FIG. 15) between the upper and lower ends 24, 26 of the corresponding heat exchanger panel 14 is between 0.80 and 1.20. In particular, in this embodiment, the ratio of the diameter D of the fan impeller 36 over the horizontal distance ULH is approximately 0.90.

In this embodiment, the casing 20 is made of sheet metal. In some embodiments, the sheet metal may be made of any other suitable, including for example one or more of steel, stainless steel, galvanized steel, aluminum, brass, zinc and the like.

As will be described below, in some embodiments, the dry cooler 10 may be provided with sound dampening devices which are disposed in the interior space 25 of the dry cooler 10 (one in each sub-compartment of the interior space 25 as defined by the enclosing panels 18, 19). These sound dampening devices can further dampen the sound generated by the dry cooler 10. Moreover, while a pressure loss can be expected in the air flow within the dry cooler 10 due to the presence of the sound dampening devices therein, this pressure loss has been found to be minimal and therefore does not affect the performance of the dry cooler 10 in a significant manner.

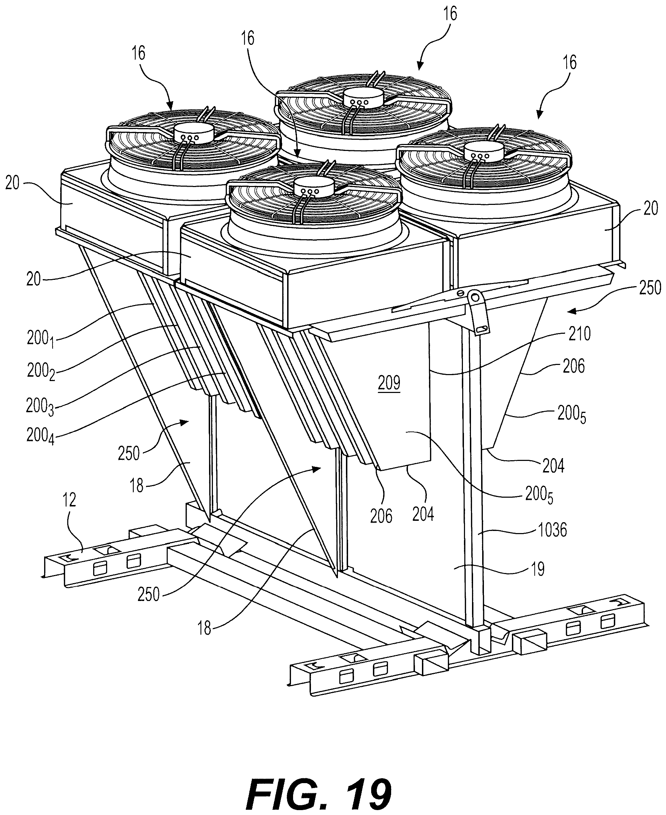

With reference to FIGs. 19 to 23, another embodiment of the dry cooler 10 will be described herein. In this embodiment, the dry cooler 10 is provided with a plurality of sound dampening devices 250 disposed within the interior space 25 of the dry cooler 10 and positioned such that at least a portion of air pulled into the interior space 25 through the heat exchanger panels 14 flows through a respective one of the sound dampening devices 250 before being discharged from the dry cooler 10 via the respective fan assembly 16.

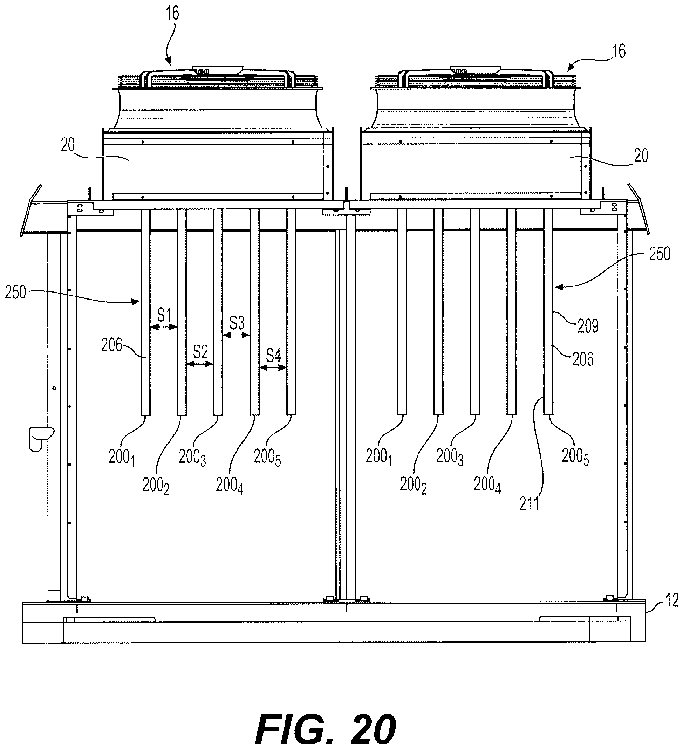

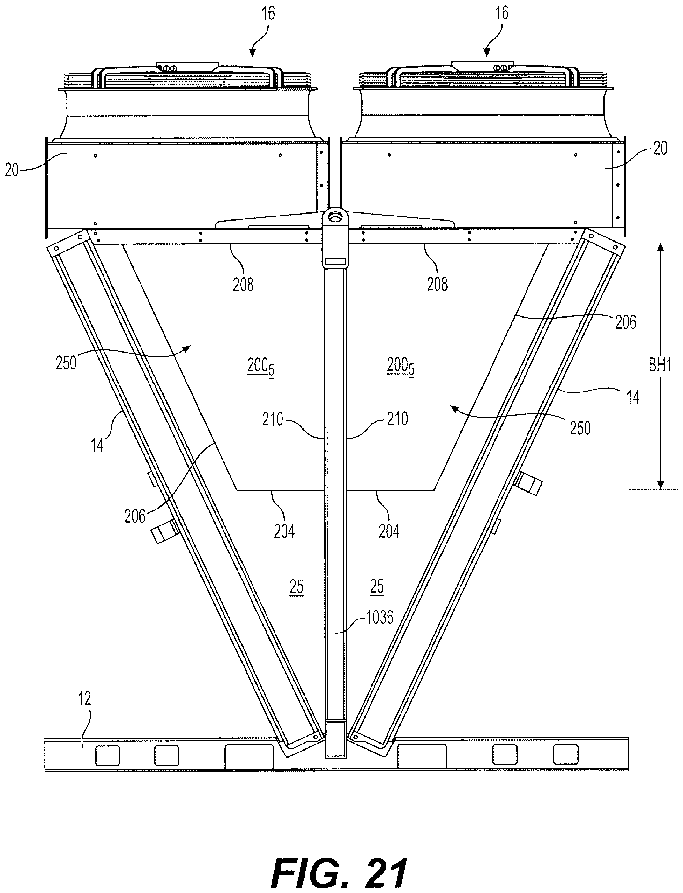

Each sound dampening device 250 includes a plurality of baffle members 200₁-200₅ which extend perpendicular to a plane extending through the upper and lower ends 26, 24 of the corresponding heat exchanger panel 14 (more clearly seen in FIG. 21). In particular, in this embodiment, the baffle members 200₁-200₅ are generally planar and, as shown in FIG. 20, each baffle member 200ᵢ has opposite lateral faces 209, 211 which define a thickness of the baffle member 200ᵢ therebetween. With continued reference to FIG. 20, consecutive ones of the baffle members 200₁-200₅ are spaced apart from one another by respective spacings S1, S2, S3, S4. In this embodiment, the spacings S1, S2, S3, S4 are constant such that a distance between consecutive ones of the baffle members 200₁-200₅ are the same. However, in other embodiments, the spacings S1, S2, S3, S4 may not be uniform such that the spacing between the consecutive baffle members 200₁-200₅ is variable. In particular, the central spacings S2, S3 may be greater than the outer spacings S1, S4. Notably, this can reduce the pressure drop caused by the presence of the sound dampening devices 250 in the interior space 25 since air flow will tend to be concentrated at central zones corresponding to areas of the corresponding heat exchanger panel 14 lying at centrally between two laterally-consecutive side enclosing panels 18 (i.e., aligned with the spacings S2, S3).

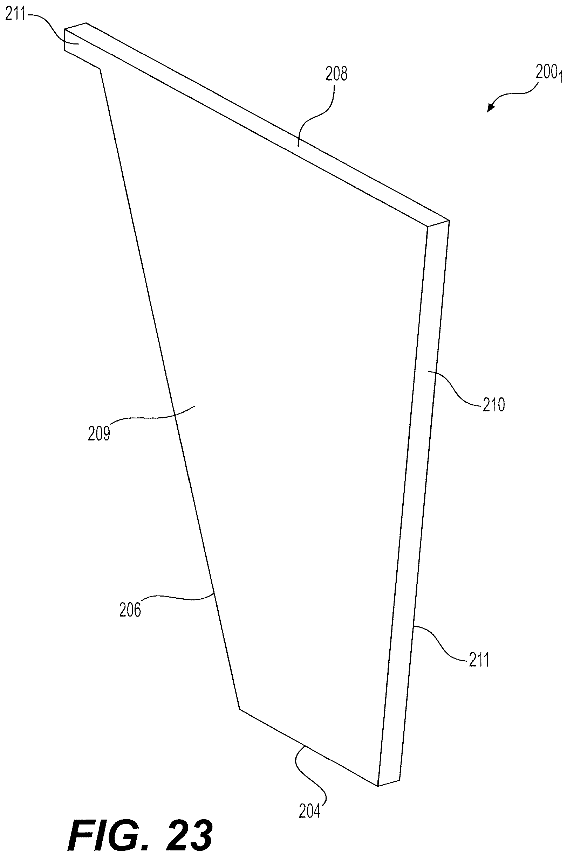

As shown in FIG. 23, each baffle member 200ᵢ has a generally triangular shape, notably having edges 206, 208, 210 which define its generally triangular shape. In particular, the upper horizontal edge 208 extends perpendicular to the vertical edge 210, while the edge 206 extends diagonally relative to the edges 208, 210. More particularly, the baffle member 200ᵢ is shaped like a truncated triangle as the baffle member 200ᵢ also has a lower horizontal edge 204 from extending between the lower ends of the edges 206, 210. When the sound dampening device 250 is in position in the interior space 25 of the dry cooler 10, the diagonal edge 206 extends adjacent to the heat exchanger panel 14. The baffle member 200ᵢ also has an extension 211 which is defined in part by the upper edge 208. The extension 211 extends outwardly from the diagonal edge 206 in a direction away from the vertical edge 210. The extension 211 is used to hang the baffle member 202ᵢ from a frame of the sound dampening device 250.

As shown in FIG. 21, a height BH1 of the baffle member 200ᵢ is defined between the lower and upper edges 204, 208. The height BH1 of the baffle member 200ᵢ is relatively significant so as to optimize a distance along which the sound dampening device 250 absorbs sound. For instance, in this embodiment, a ratio of the height BH1 of the baffle member 200ᵢ over the vertical distance ULV between the lower and upper ends 24, 26 of the corresponding heat exchanger panel 14 is approximately 0.5. This ratio may be even greater in other embodiments. For example, the ratio of the height BH1 of the baffle member 200ᵢ over the vertical distance ULV may be between 0.3 and 0.8.

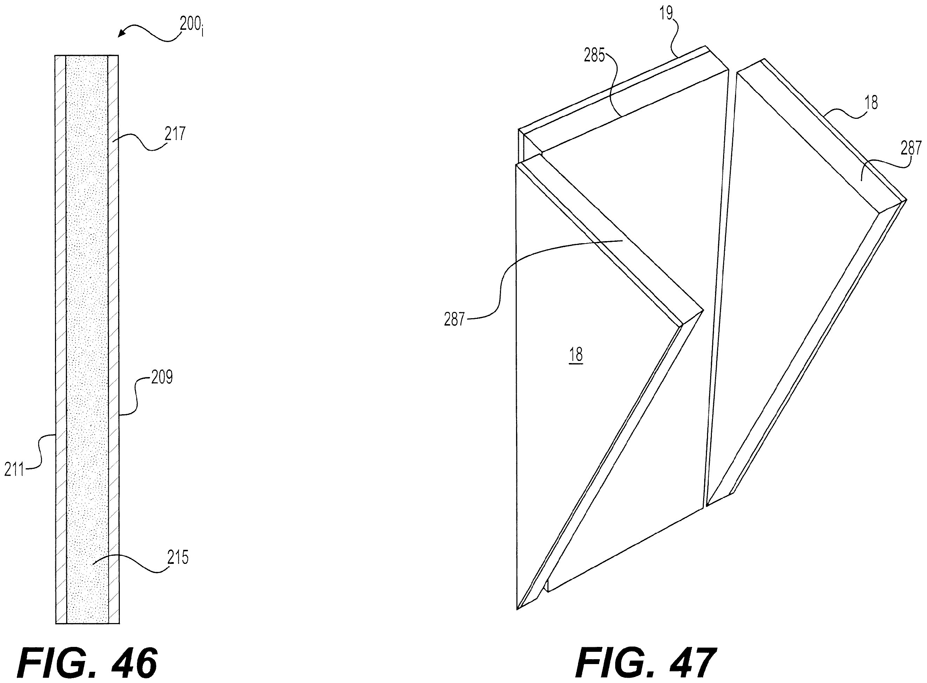

With reference to FIG. 46 which shows a cross-section of part of one of the baffle members 200₁-200₅, in this embodiment, each baffle member 200ᵢ comprises a sound absorbing material 215 and a protective layer 217 covering the sound absorbing material 215. In some embodiments, the protective layer 217 may cover only part of the sound absorbing material 215. In this embodiment, the protective layer 217 surrounds the sound absorbing material 215 from both faces 209, 211. Moreover, in this embodiment, the sound absorbing material 215 comprise a foam material such as polyurethane foam. However, it is contemplated that any other suitable sound absorbing material may be used, such as for example, fiberglass, mineral wool, or cotton. The protective layer 217 is configured to protect the sound absorbing material, such as from exposure to high heat as well as from tears. In this embodiment, the protective layer 217 is made of metallic material such as aluminum. Other suitable types of materials are also contemplated for the protective layer 217.

The sound dampening device 250 is held in place by a frame (not shown) which is connected to each of the baffle members 200₁-200₅ so as to suspend the baffle members therefrom. Notably, the frame of the sound dampening device 250 is connected to the frame 12 of the heat exchanger assembly 10, and more specifically between the frame 12 and a corresponding one of the casings 20. As such, the baffle members 200₁-200₅ are spaced from the heat exchanger panel 14.

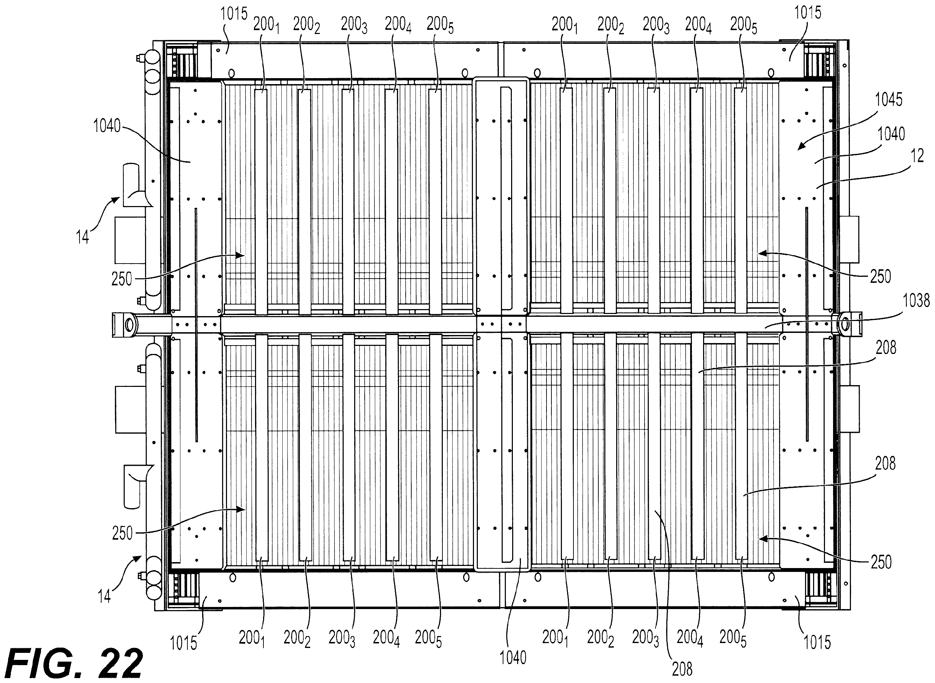

In this embodiment, as shown in FIGs. 20 and 22, each sound dampening device 250 is generally centered between the two side enclosing panels 18 defining the corresponding sub-compartment of the interior space 25 in which the sound dampening device 250 is positioned.

The sound dampening device 250 thus absorbs sound from the air flow prior to its entry into the corresponding fan assembly 16. Since it has been found that the main source of sound generated by the dry cooler 10 is located at the lower end of the fan assembly 16, as air gets aspirated into the fan assembly 16, the sound dampening device 250 thus significantly dampens the sound generated by the dry cooler 10. Notably, the flow of air through the heat exchanger panel 14 is not a significant source of sound and therefore by dampening the sound generated by the dry cooler 10 at the fan assembly 16, the sound generated by the dry cooler 10 is significantly dampened.

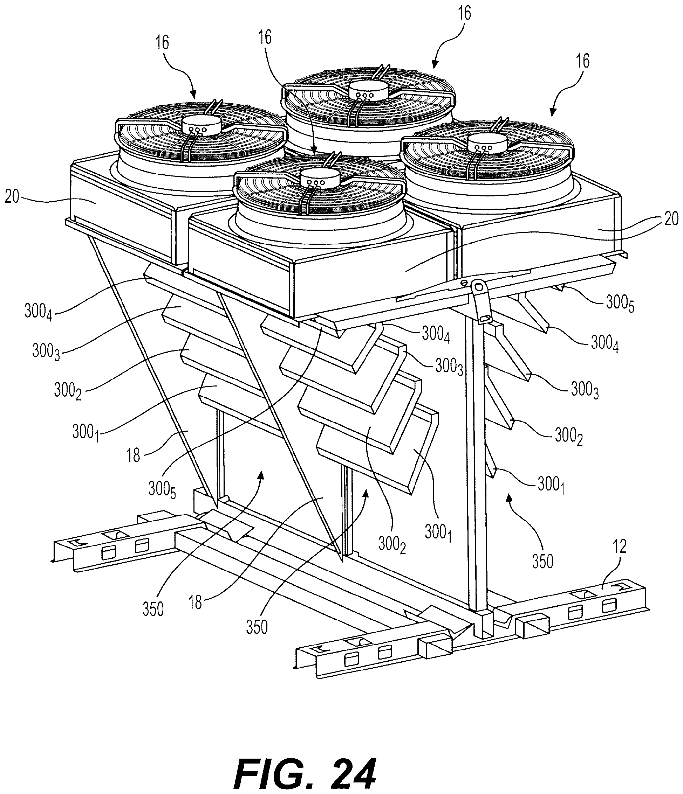

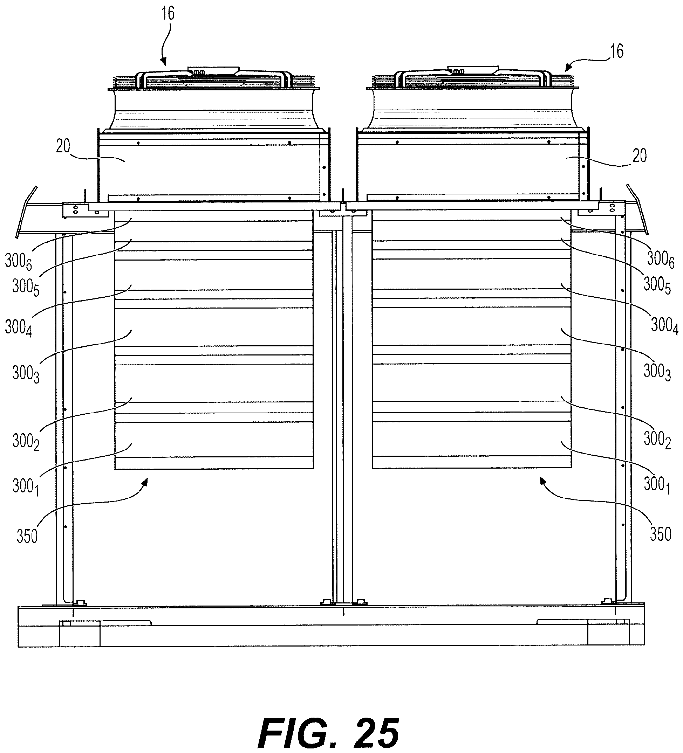

Another embodiment of the sound dampening device will now be described with particular reference to FIGs. 24 to 28. In this embodiment, the dry cooler 10 is provided with a plurality of sound dampening devices 350 disposed within the interior space 25 of the dry cooler 10 and positioned such that at least a portion of air pulled into the interior space 25 through the heat exchanger panels 14 flows through a respective one of the sound dampening devices 350 before being discharged from the dry cooler 10 via the respective fan assembly 16.

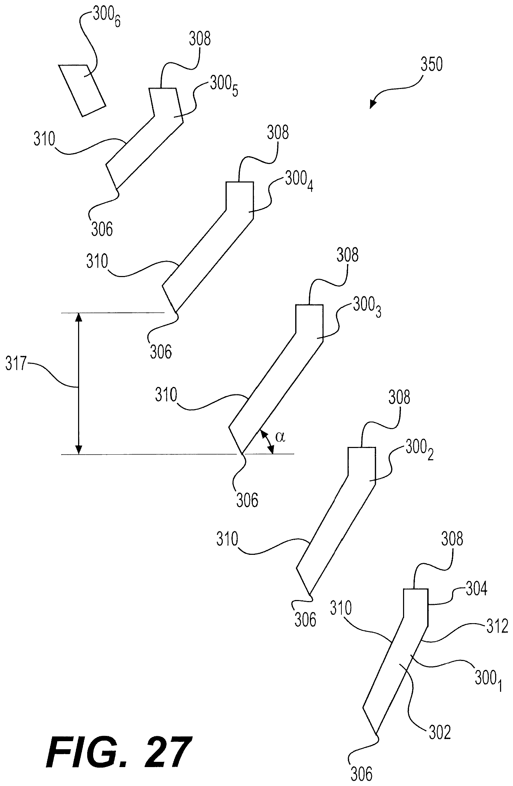

Each sound dampening device 350 includes a plurality of baffle members 300₁-300₅ spaced apart from one another for allowing air flow therebetween. As will be described in greater detail below, each of the baffle members 300₁-300₅ is shaped and positioned so as to direct air flow upwardly toward the fan assembly 16. This may help reduce formation of vortices in the air flow and thus optimizes performance of the dry cooler 10 provided with the sound dampening devices 250. In particular, the baffle members 300₁-300₅ extend generally at an angle relative to a plane extending through the lower and upper ends 24, 26 of the heat exchanger panel 14 so as to direct air flow upwardly toward the fan assembly 16. As such, as shown in FIG. 27, an upper end 308 of each baffle member 300ᵢ is located vertically higher than a lower end 306 thereof.

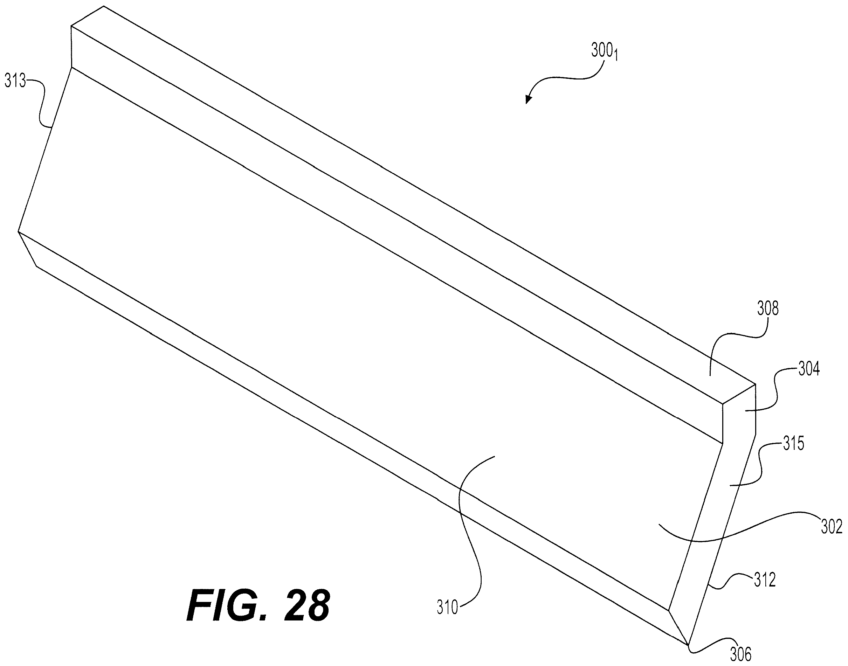

As shown in FIG. 28, each baffle member 300ᵢ extends from a first lateral end 313 to a second lateral end 315, defining a width of the baffle member 300ᵢ therebetween. The baffle member 300ᵢ has a first portion 302 and a second portion 304 extending from the first portion 302, and more particularly extending upwardly at an angle relative to the first portion 304. As such, the second portion 304 defines the upper end 308 of the baffle member 300ᵢ while the first portion 302 defines the lower end 306 of the baffle member 300ᵢ. In this embodiment, the second portion 304 extends generally vertically. Both portions 302, 304 extend across an entirety of the width of the baffle member 300ᵢ, however it is contemplated that one of the portions 302, 304 could extend along a limited part of the width of the baffle member 300ᵢ (i.e., one of the portions 302, 304 could have a shorter span in the width direction than the other).

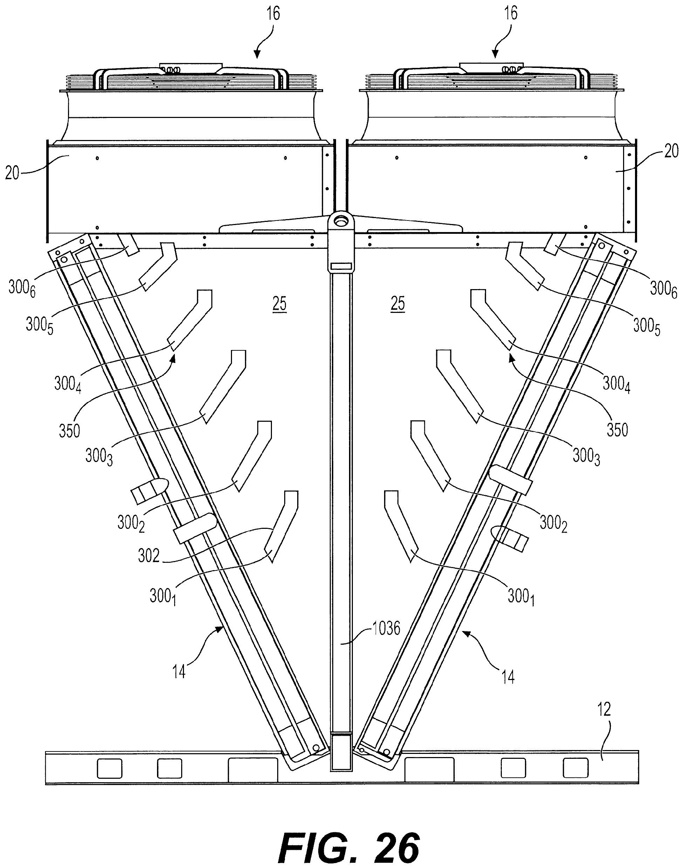

As can be seen in FIG. 26, when the sound dampening device 350 is in position in the interior space 25 of the dry cooler 10, the first portion 302 is positioned closer to the heat exchanger panel 14 than the second portion 304. As such, air pulled into the dry cooler 10 and flowing through the sound dampening device 350 traverses along the first portion 302 of each baffle member 300ᵢ before reaching the second portion 304 thereof. The first portion 302 extends at an angle α (FIG. 27) relative to a horizontal plane so as to direct air flow upwardly. In this embodiment, the angle α may be between 40° and 75° inclusively. The angle α may vary for each baffle member 300ᵢ. For instance, as shown in FIG. 27, in this embodiment, the angle α is greater for lower ones of the baffle members 300₁-300₅ (e.g., the baffle member 300₁) and smaller for upper ones of the baffle members 300₁-300₅ (e.g., the baffle member 300₅). Moreover, as the second portion 304 extends upwardly at an angle relative to the first portion 302, the second portion 304 deflects air flow incoming from a direction of the first portion 304.

With reference to FIG. 27, in this embodiment, a spacing 317 between consecutive ones of the baffle members 300₁-300₅ is variable. Notably, the spacing 317 may be greater between the more centrally positioned baffle members 300₂ and 300₃, as well as between the baffle members 300₃ and 300₄. This may help reduce pressure loss caused by the presence of the sound dampening devices 350 within the interior space 25 of the dry cooler 10. For simplicity, the spacing 317 is measured between the lower end 306 of a given one of the baffle members 300₁-300₅ and a consecutive one of the baffle members 300₁-300₅ below the given one of the baffle members 300₁-300₅. It is contemplated that the spacing 317 may be constant between the consecutive baffle members 300₁-300₅ in other embodiments.

Furthermore, the baffle members 300₁-300₅ are positioned relative to one another such that consecutive ones of the baffle members 300₁-300₅ overlap one another vertically. This may ensure that air does not flow past the baffle members 300₁-300₅ without being redirected thereby. More specifically, as shown in FIG. 27, the lower end 306 of a given one of the baffle members 300₁-300₅ is positioned vertically lower than the upper end 308 of a consecutive baffle member 300ᵢ positioned below the given one of the baffle members 300₁-300₅.

In this embodiment, the sound dampening device 350 also includes an upper baffle member 300₆ which is disposed vertically higher than all of the baffle members 300₁-300₅. The baffle member 300₆ restricts air flow above the baffle member 300₅. The upper baffle member 300₆ is positioned to direct part of the air flow entering through the heat exchanger panel 14 towards the upper end 26 of thereof (i.e., towards the spoiler 60 and its inner wall 62).

The sound dampening device 350 is held in place by a frame similar to the frame described with respect to the sound dampening device 250.

The baffle members 300₁-300₆ of the sound dampening device 350 are constructed similarly to the baffle members 200₁-200₅ described above. In particular, each baffle member 300ᵢ comprises a sound absorbing material and a protective layer similar to those of the baffle members 200₁-200₅. The construction of the baffle members 300₁-300₆ will therefore not be described in detail herein.

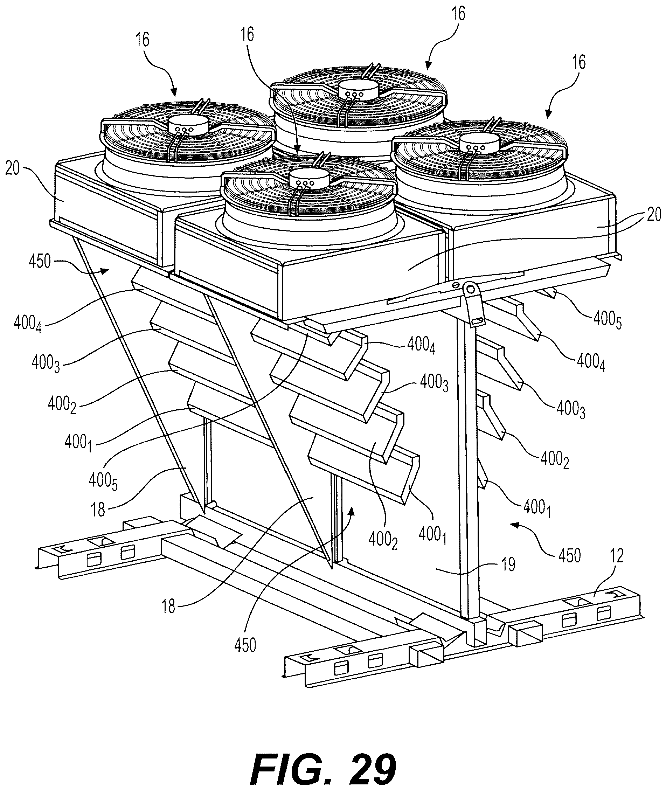

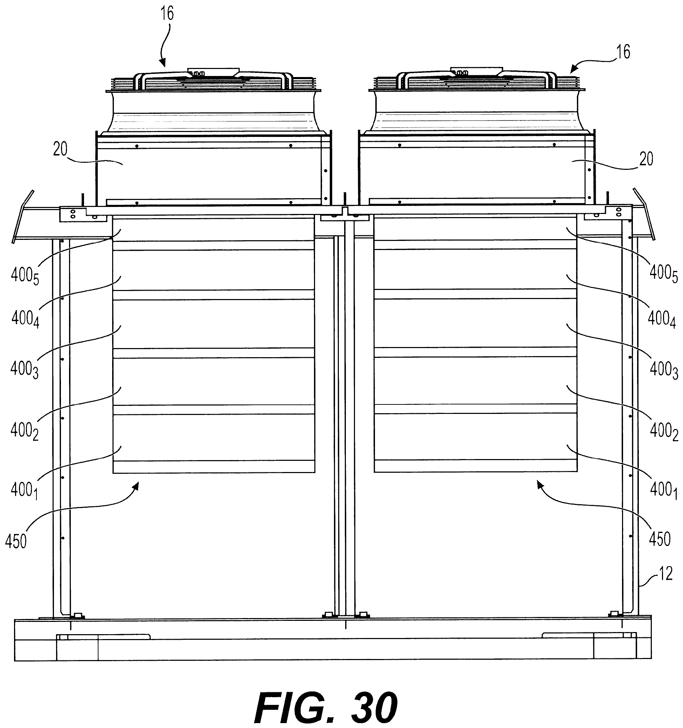

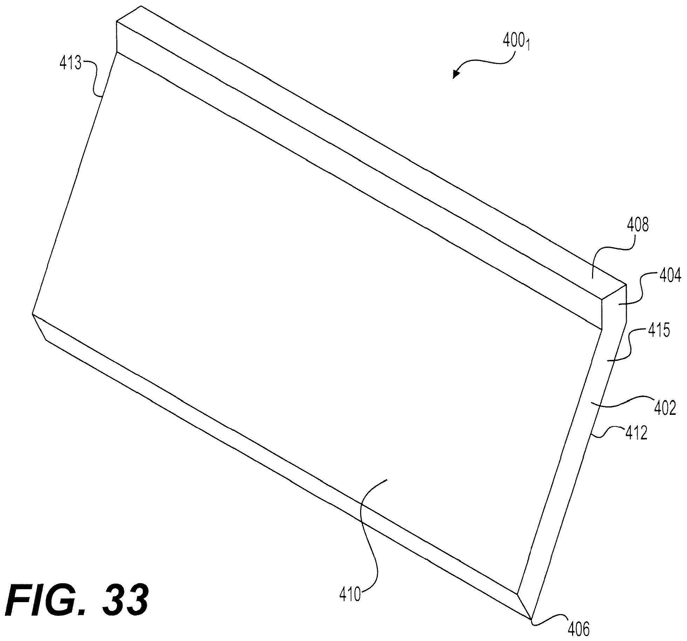

Another embodiment of the sound dampening device will now be described with particular reference to FIGs. 29 to 33. In this embodiment, the dry cooler 10 is provided with a plurality of sound dampening devices 450 disposed within the interior space 25 of the dry cooler 10 and positioned such that at least a portion of air pulled into the interior space 25 through the heat exchanger panels 14 flows through a respective one of the sound dampening devices 450 before being discharged from the dry cooler 10 via the respective fan assembly 16.

Each sound dampening device 450 includes a plurality of baffle members 400₁-400₅ spaced apart from one another for allowing air flow therebetween. Each of the baffle members 400₁-400₅ is shaped and positioned so as to direct air flow upwardly toward the fan assembly 16. Notably, the baffle members 400₁-400₅ are generally configured in the same manner as the baffle members 300₁-300₅ of the sound dampening device 350 described above. As such, the baffle members 400₁-400₅ will not be described herein in detail except for the notable differences thereof relative to the baffle members 300₁-300₅. The features of the sound dampening device 450 and of the baffle members 400₁-400₅ thereof have therefore been denoted with the same reference numbers as those equivalent features of the sound dampening device 350 and of the baffle members 300₁-300₅, with the numbers however being in the "400" series instead of the "300" series.

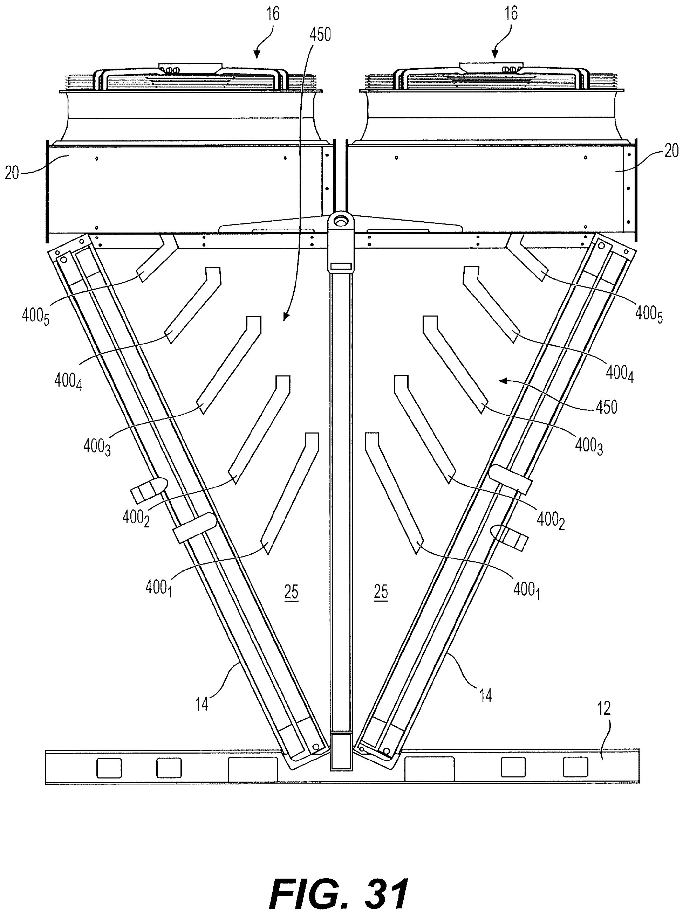

As can be seen clearly in FIG. 31, the baffle members 400₁-400₅ are longer than the baffle members 300₁-300₅. For instance, a straight line distance between the lower end 406 and the upper end 408 of each baffle member 400ᵢ is greater than a straight line distance between the lower end 306 and the upper end 308 of each baffle member 300ᵢ. Similarly, a vertical distance between the lower end 406 and the upper end 408 of each baffle member 400ᵢ is greater than a vertical distance between the lower end 306 and the upper end 308 of each baffle member 300ᵢ. Moreover, as the baffle members 400₁-400₈ are no longer in this embodiment, they may be operable to absorb sound to a greater extent than the corresponding one.

As such, the vertical overlap between consecutive baffle members 400₁-400₅ is greater than for the baffle members 300₁-300₅. More specifically, as shown in FIG. 31, the lower end 406 of a given one of the baffle members 400₁-400₅ is positioned vertically lower than the upper end 408 of a consecutive baffle member 400ᵢ positioned below the given one of the baffle members 400₁-400₅.

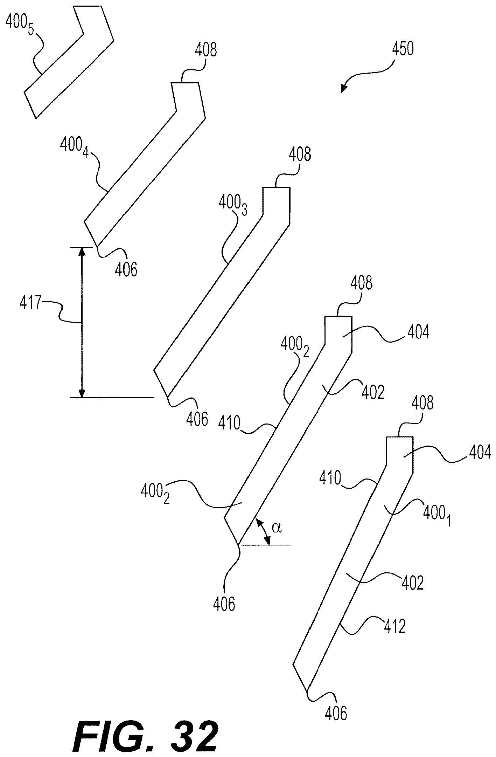

Furthermore, in this embodiment, the lengths of the baffle members 400₁-400₅ (i.e., the distance between the lower and upper ends 406, 408) are different. In particular, as shown in FIG. 32, the baffle members 400₁-400₅ are increasingly longer from the bottommost baffle member 400₅ to the topmost baffle member 400₁. Thus, the bottommost baffle member 400₅ is longer than the other baffle members 400₁-400₄, and the topmost baffle member 400₁ is the shorter than the other baffle members 400₂-400₅. As air flow entering the sound dampening device 450 at the bottom of the heat exchanger panel 14 has a greater distance to travel to the fan assembly 16, this configuration may provide greater directionality to that air flow as the baffle members 400₁-400₅ located near the bottom of the heat exchanger panel 14 guide air flow over a longer distance (i.e., further upwardly) thus providing a better distribution of air flow.

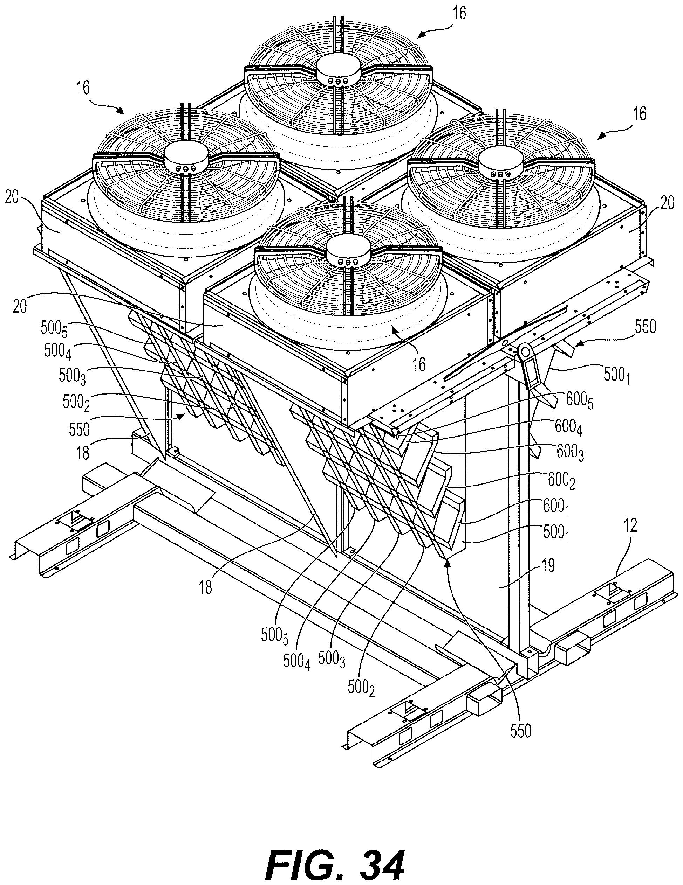

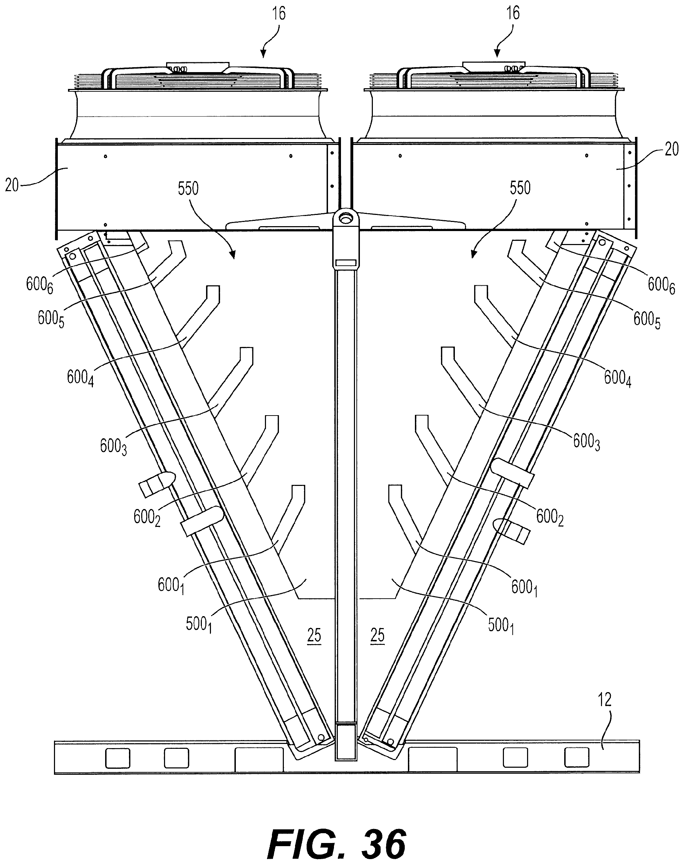

Another embodiment of the sound dampening device will now be described with particular reference to FIGs. 34 to 39. In this embodiment, the dry cooler 10 is provided with a plurality of sound dampening devices 550 disposed within the interior space 25 of the dry cooler 10 and positioned such that at least a portion of air pulled into the interior space 25 through the heat exchanger panels 14 flows through a respective one of the sound dampening devices 550 before being discharged from the dry cooler 10 via the respective fan assembly 16.

In this embodiment, each sound dampening device 550 includes two types of baffle members which are affixed to one another to form the sound dampening device 550. In particular, the sound dampening device 550 includes a plurality of upright baffle members 500₁-500₅ and a plurality of angled baffle members 600₁-600₅. The upright baffle members 500₁-500₅ are similar to the baffle members 200₁-200₅ described above with respect to the sound dampening device 250, and therefore the particular configuration of the upright baffle members 500₁-500₅ will not be described in detail herein, except to describe notable differences therebetween. The features of the upright baffle members 500₁-500₅ have therefore been denoted with the same reference numbers as those equivalent features of the baffle members 200₁-200₅, with the numbers however being in the "500" series instead of the "200" series. Similarly, the angled baffle members 600₁-600₅ are similar to the baffle members 300₁-300₅ described above with respect to the sound dampening device 350, and therefore the particular configuration of the angled baffle members 600₁-600₅ will not be described in detail herein, except to describe notable differences therebetween. The features of the angled baffle members 600₁-600₅ have therefore been denoted with the same reference numbers as those equivalent features of the baffle members 300₁-300₅, with the numbers however being in the "600" series instead of the "300" series.

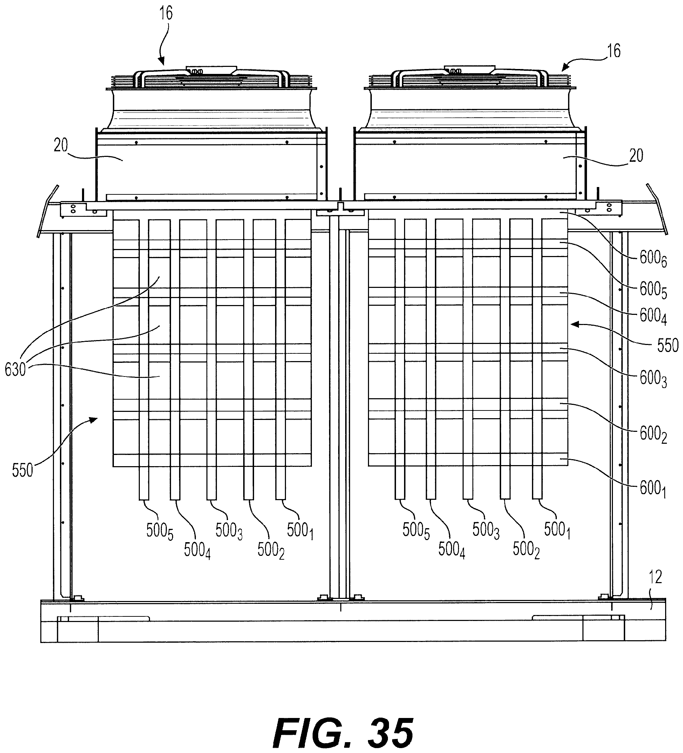

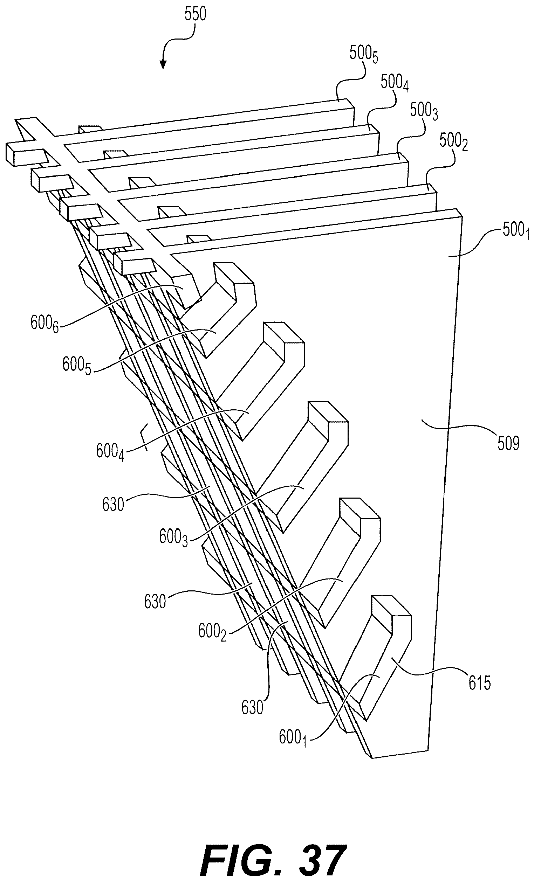

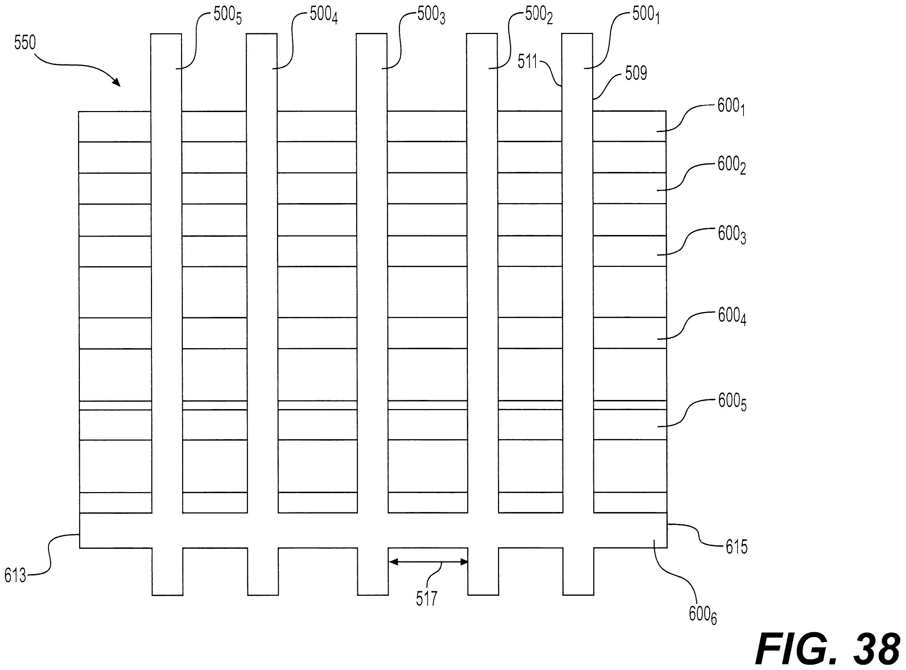

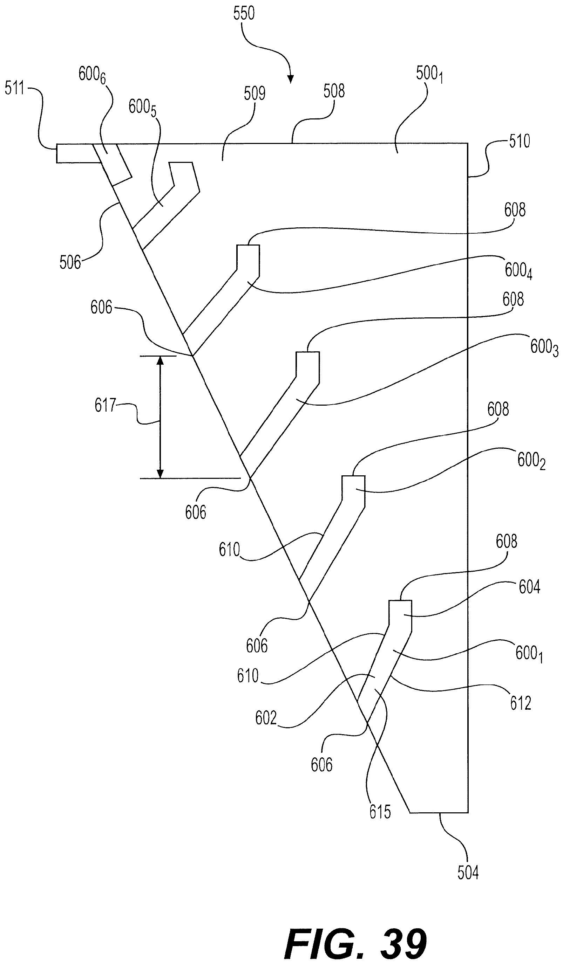

As can be seen, the upright baffle members 500₁-500₅ extend perpendicular to the angled baffle members 600₁-600₅ and to the plane extending through the upper and lower ends 26, 24 of the corresponding heat exchanger panel 14. As the upright baffle members 500₁-500₅ are spaced apart from one another (by a variable spacing 517 - FIG. 38) and the angled baffle members 600₁-600₅ are also spaced apart from one another (by variable spacing 617 - FIG. 39), together, the upright and angled baffle members 500₁-500₅, 600₁-600₅ form air ducts 630 therebetween, as shown in FIGs. 35 and 37. Notably, each air duct 630 is defined by: (i) the rear face 612 of one of the angled baffle members 600₂-600₅; (ii) the front face 610 of a consecutive lower one of the angled baffle members 600₁-600₄; (iii) the lateral face 509 of one of the upright baffle members 500₂-500₅; and (iv) the opposite lateral face 511 of a consecutive one of the upright baffle members 500₁-500₄. As such, as can be seen in FIG. 35, the upright and angled baffle members 500₁-500₅, 600₁-600₅ form a rectangular grid which defines the air ducts 630.

In this embodiment, the upright and angled baffle members 500₁-500₅, 600₁-600₅ are affixed to one another by forming recesses in the upright baffle members 500₁-500₅ or the angled baffle members 600₁-600₅ in which the other of the upright baffle members 500₁-500₅ or the angled baffle members 600₁-600₅ are received. In other words, the upright and angled baffle members 500₁-500₅, 600₁-600₅ are interlocked with one another. The upright and angled baffle members 500₁-500₅, 600₁-600₅ may be affixed to one another in any other suitable way in other embodiments.

The sound dampening device 550 thus offers the benefits of having both types of baffle members, notably providing directionality to the air flow via the angled baffle members 600₁-600₅ while also providing greater sound absorption due to the size and weight of the baffle members 500₁-500₅.

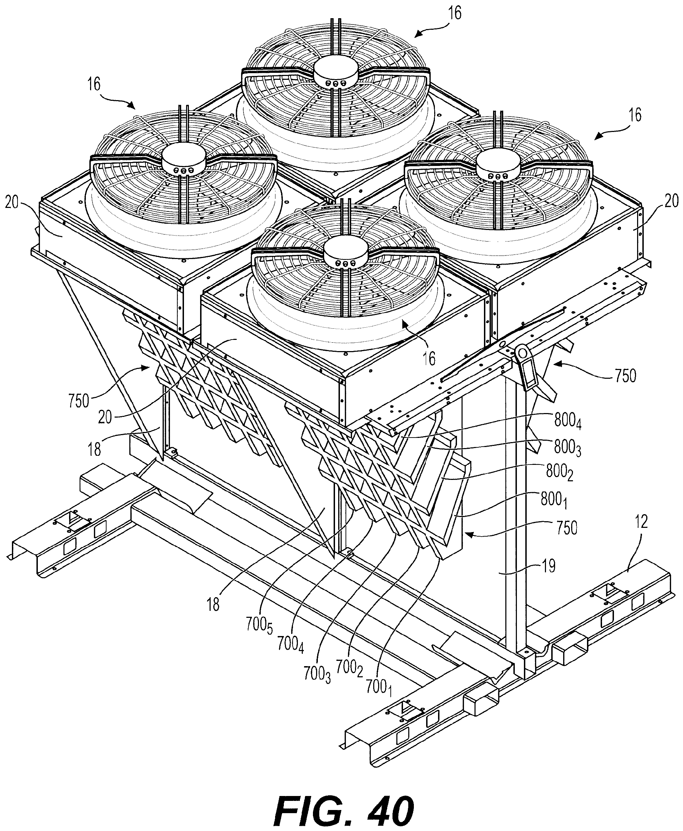

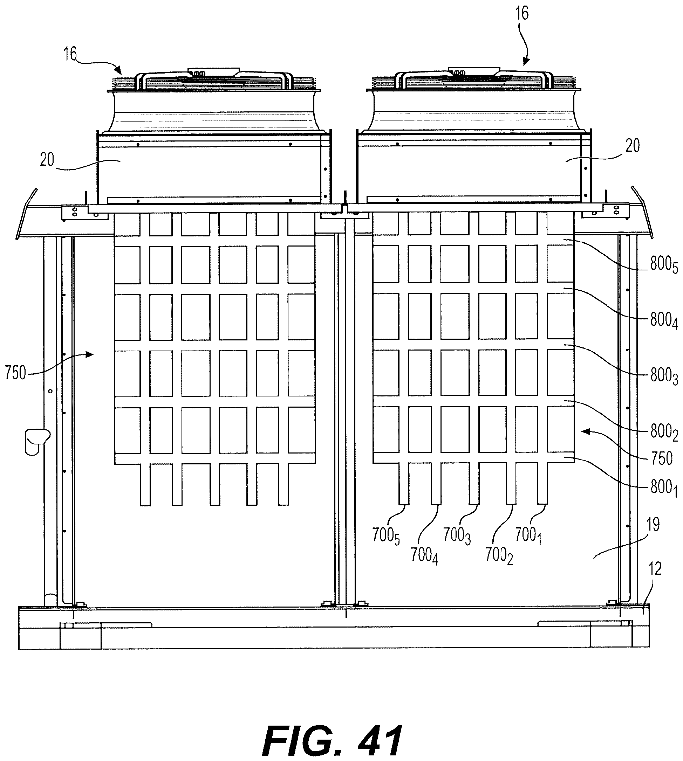

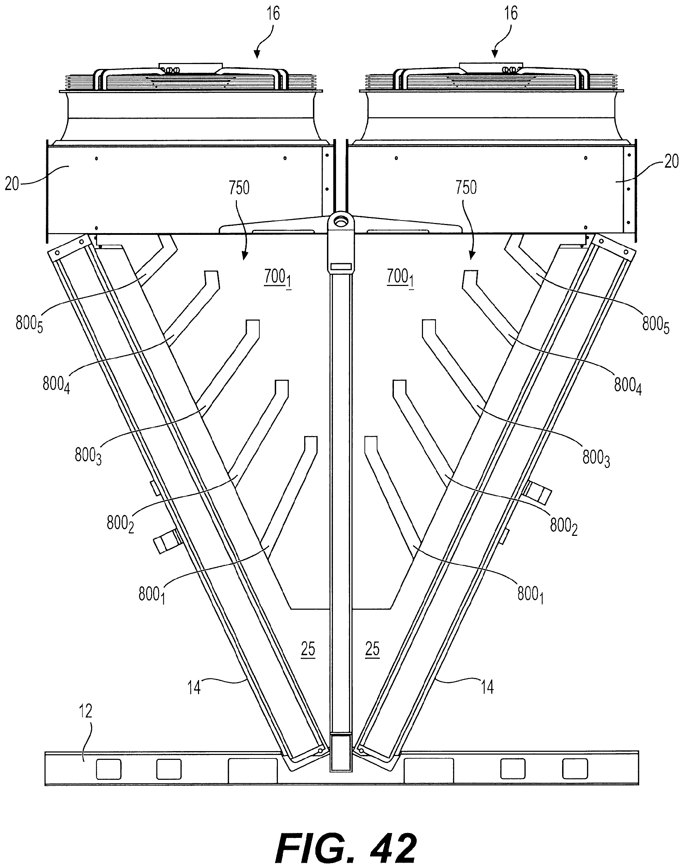

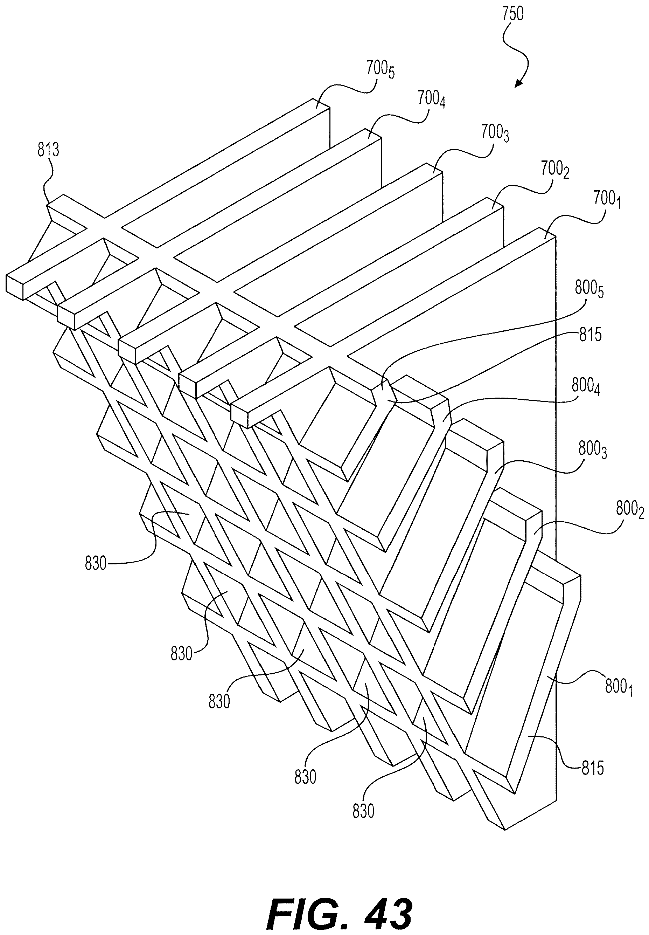

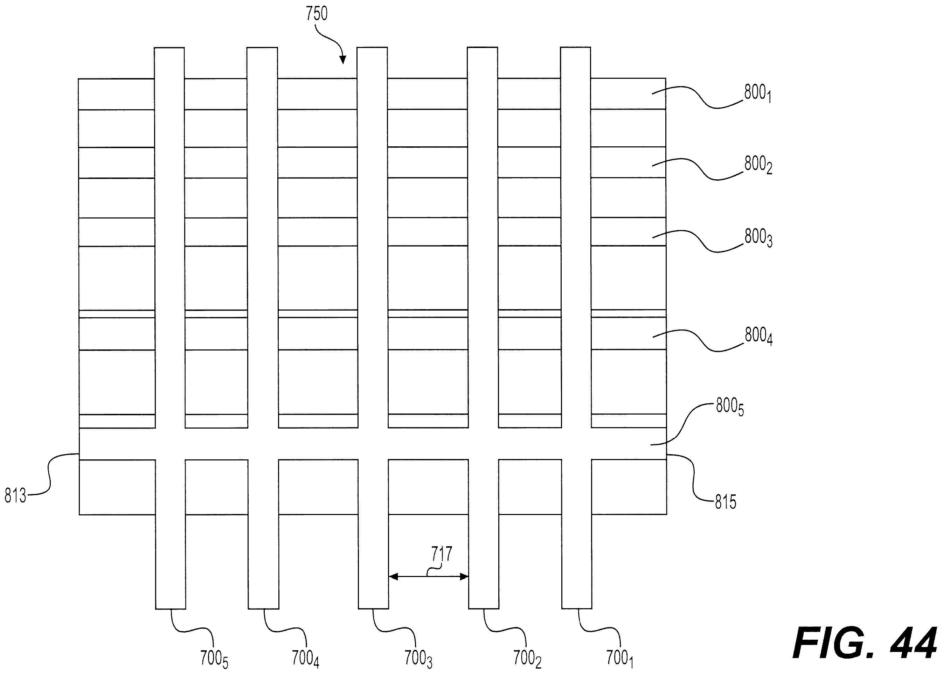

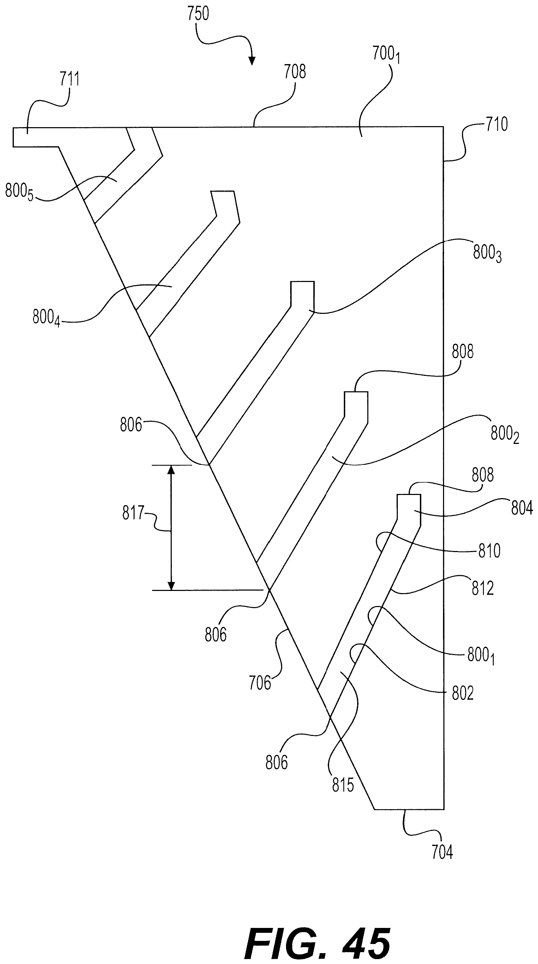

Another embodiment of the sound dampening device is shown in FIGs. 40 to 45. In this embodiment, the dry cooler 10 is provided with a plurality of sound dampening devices 750 disposed within the interior space 25 of the dry cooler 10 and positioned such that at least a portion of air pulled into the interior space 25 through the heat exchanger panels 14 flows through a respective one of the sound dampening devices 750 before being discharged from the dry cooler 10 via the respective fan assembly 16.

As can be seen, the sound dampening device 750 is similar to the sound dampening device 550 described above. Notably, in this embodiment, each sound dampening device 750 includes two types of baffle members which are affixed to one another to form the sound dampening device 550. In particular, the sound dampening device 750 includes a plurality of upright baffle members 700₁-700₅ and a plurality of angled baffle members 800₁-800₅. The upright baffle members 700₁-700₅ are similar to the baffle members 200₁-200₅ described above with respect to the sound dampening device 250, and therefore the particular configuration of the upright baffle members 700₁-700₅ will not be described in detail herein, except to describe notable differences therebetween. The features of the upright baffle members 700₁-700₅ have therefore been denoted with the same reference numbers as those equivalent features of the baffle members 200₁-200₅, with the numbers however being in the "700" series instead of the "200" series. Similarly, the angled baffle members 800₁-800₅ are similar to the baffle members 400₁-400₅ described above with respect to the sound dampening device 350, and therefore the particular configuration of the angled baffle members 800₁-800₅ will not be described in detail herein, except to describe notable differences therebetween. The features of the angled baffle members 800₁-800₅ have therefore been denoted with the same reference numbers as those equivalent features of the baffle members 400₁-400₅, with the numbers however being in the "800" series instead of the "400" series.

Thus, in this embodiment, the sound dampening device 750 has longer angled baffle members 800₁-800₅ than is provided for in the sound dampening device 550 described above. As explained with reference to the sound dampening device 450, the longer angled baffle members 800₁-800₅ may provide greater directionality to the air flow than if shorter angled baffle members were used instead.

The sound dampening devices described above are all interiorly contained within the dry cooler 10. That is, each embodiment of the sound dampening device described above is disposed within the interior space 25 of the dry cooler 10. This results in a less burdensome dry cooler 10 than if an outer sound dampening solution were implemented, while also leaving space free outside of the dry cooler 10 for other systems which can benefit the operation of the dry cooler 10. For example, in some cases, it may be desirable to install an atomizer unit outside of the dry cooler 10 configured to spray water in the direction of the heat exchanger panels 14 such as to cool the air flowing into the dry cooler 10. Therefore, having a sound dampening device installed in the interior space 25 of the dry cooler 10 affords space outside of the dry cooler 10 for such an atomizer unit or other equipment which can be mounted outside of the dry cooler.

Furthermore, the sound dampening devices described above are relatively light and therefore do not add significant weight to the dry cooler 10 while reducing its operating noise substantially. In addition, as a result, the sound dampening devices are also easy to install and do not require heaving lifting equipment. Moreover, a dry cooler or other heat exchanger assembly can be retrofitted with such sound dampening devices.

The dry cooler 10 implementing the casings 20 and one of the sound dampening devices described above is particularly quiet. However, it should be noted that even if only the casings 20 or only the sound dampening devices were implemented, the dry cooler 10 would still be significantly quieter compared to a conventional dry cooler. For instance, the sound dampening devices described above absorb sound prior to the air flow's entry into the fan assembly 16 irrespective of whether or not the dry cooler 10 is provided with the casings 20. Similarly, the casings 20 reduce sound generated by the dry cooler 10 irrespective of whether or not the dry cooler 10 is provided with the sound dampening devices. Thus both solutions are workable independently as well as in combination.

With reference to FIG. 47, which shows a sub-compartment of the interior space 25 defined in part by two side enclosing panels 18 and a middle panel 19, in some embodiments, the dry cooler 10 may additionally be provided with acoustic panels 285, 287 which are connected to and at least partially cover the enclosing panels 18, 19. Notably, the acoustic panels 285, 287 acoustically insulate the interior space 25 of the dry cooler 10 thus providing quieter operation of the dry cooler 10. In addition, the acoustic panels 285, 287 may rigidify the enclosing panels 18, 19 and thereby dampen vibrations thereof which results in less sound generated thereby. The acoustic panels 285, 287 can be implemented in complement with any of the sound dampening devices described above, or independently thereof.

It is to be understood that, while the dry cooler 10 has been described herein as being oriented vertically or upright such that the fan rotation axes FA extend generally vertically, it is contemplated that similar sound attenuating solutions such as the casings 20, the sound dampening devices and the acoustic panels 285, 287 may be implemented similarly in a dry cooler that is oriented horizontally such that the fan rotation axes FA extend horizontally. In that context, it is to be understood that terms referring to the positioning or orientation of the different component of the dry cooler 10 (e.g., upper, lower, etc.) are to be interpreted with an up-down direction of the dry cooler 10 being consistent with the direction of the fan rotation axes FA.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A heat exchanger assembly (10), comprising:
a frame (12);
a heat exchanger panel (14) mounted to the frame (12) and configured to exchange heat with air flowing therethrough, the heat exchanger panel (14) having a lower end (24) and an upper end (26), the heat exchanger panel (14) being disposed at an inclined orientation such that the upper and lower ends (26, 24) thereof are offset from one another, the heat exchanger panel (14) comprising:
a tubing arrangement (28) for circulating fluid therein; and
a plurality of fins (33) in thermal contact with the tubing arrangement (28), the fins (33) being spaced apart from one another for air to flow therebetween and into an interior space (25) of the heat exchanger assembly (10);
a plurality of enclosing panels (18, 19) connected to the frame (12) and defining in part the interior space (25) of the heat exchanger assembly (10);
a fan assembly (16) disposed vertically above the heat exchanger panel (14), the fan assembly (16) comprising a fan impeller (36) rotatable about a fan rotation axis (FA) to pull air into the interior space (25) of the heat exchanger assembly (10) through the heat exchanger panel (14) and evacuate heated air upwardly from the interior space (25) of the heat exchanger assembly (10) through the fan assembly (16);
**characterized by**:
a sound dampening device (550) disposed within the interior space (25) of the heat exchanger assembly (10) such that air is pulled into the interior space (25) through the heat exchanger panel (14) and then flows through the sound dampening device (550) before being discharged from the heat exchanger assembly (10) via the fan assembly (16), the sound dampening device (550) comprising:
a plurality of baffle members (600₁-600₅), the baffle members (600₁-600₅) being spaced apart from one another for allowing air flow therebetween, each of the baffle members (600₁-600₅) extending at an angle relative to a plane extending through the upper and lower ends (26, 24) of the heat exchanger panel (14) so as to direct air flow upwardly toward the fan assembly (16).

2. The heat exchanger assembly of claim 1, wherein:
each of the baffle members (600₁-600₅) has a first portion (602) and a second portion (604) extending from the first portion (602);
the first portion (602) is positioned closer to the heat exchanger panel (14) than the second portion (602) such that air pulled into the heat exchanger assembly (10) and flowing through the sound dampening device (550) traverses along the first portion (602) of each of the baffle members (600₁-600₅) before reaching the second portion (604) thereof; and
the second portion (604) extends upwardly at an angle relative to the first portion (602) to deflect air flow incoming from a direction of the first portion (602).

3. The heat exchanger assembly of claim 2, wherein the second portion (604) of each baffle member (600₁-600₅) extends generally vertically.

4. The heat exchanger assembly of claim 2 or 3, wherein the first portion (602) of each baffle member (600₁-600₅) extends at an angle between 40° and 75° inclusively relative to a horizontal plane.

5. The heat exchanger assembly of any one of claims 1 to 4, wherein a spacing (617) between consecutive ones of the baffle members (600₁-600₅) is variable.

6. The heat exchanger assembly of any one of claims 1 to 5, wherein:
each of the baffle members (600₁-600₅) has an upper end (608) and a lower end (606); and
the lower end (606) of a given one of the baffle members (600₁-600₅) is positioned vertically lower than the upper end (608) of a consecutive one of the baffle members (600₁-600₅) positioned below the given one of the baffle members (600₁-600₅).

7. The heat exchanger assembly of any one of claims 1 to 6, wherein:
the baffle members (600₁-600₅) are first baffle members;
the sound dampening device (550) further comprises:
a plurality of second baffle members (500₁-500₅) affixed to the first baffle members (600₁-600₅), the second baffle members (500₁-500₅) extending perpendicular to the first baffle members (600₁-600₅) and to the plane extending through the upper and lower ends (26, 24) of the heat exchanger panel (14), the second baffle members (500₁-500₅) being spaced apart from one another, the first baffle members (600₁-600₅) and the second baffle members (500₁-500₅) forming air ducts (630) therebetween.

8. The heat exchanger assembly of claim 7, wherein the first baffle members (600₁-600₅) and the second baffle members (500₁-500₅) form a rectangular grid defining the air ducts (630).

9. The heat exchanger assembly of claim 7 or 8, wherein each of the second baffle members (500₁-500₅) has a generally triangular shape.

10. The heat exchanger assembly of claim 9, wherein, each of the second baffle members (500₁-500₅) comprises:
a first edge (508);
a second edge (510) extending perpendicularly to the first edge (508); and
a third edge (506) extending diagonally relative to the first and second edges (508, 510),
the third edge (506) being adjacent to the heat exchanger panel (14).

11. The heat exchanger assembly of any one of claims 7 to 10, wherein a spacing (517) between consecutive ones of the second baffle members (500₁-500₅) is variable.

12. The heat exchanger assembly of any one of claims 1 to 11, further comprising:
a plurality of acoustic panels (285, 287) connected to the enclosing panels (18, 19) for acoustically insulating the interior space (25) of the heat exchanger assembly (10).

13. The heat exchanger assembly of any one of claims 1 to 12, wherein:
the heat exchanger panel (14) is a first heat exchanger panel (14);
the fan assembly (16) is a first fan assembly, and the fan rotation axis is a first fan rotation axis;
the sound dampening device (550) is a first sound dampening device; and
the heat exchanger assembly (10) further comprises:
a second heat exchanger panel (14) mounted to the frame (12) and configured to exchange heat with air flowing therethrough, the second heat exchanger panel (14) having a lower end (24) and an upper end (26), the second heat exchanger panel (14) being disposed at an inclined orientation such that the upper and lower ends (26, 24) thereof are offset from one another, the first and second heat exchanger panels (14) being disposed in a V-configuration such that a distance between the upper ends (26) of the first and second heat exchanger panels (14) is greater than a distance between the lower ends (24) of the first and second heat exchanger panels (14), the second heat exchanger panel (14) comprising:
a tubing arrangement (28) for circulating fluid therein; and
a plurality of fins (33) in thermal contact with the tubing arrangement (28) of the second heat exchanger panel (14), the fins (33) of the second heat exchanger panel (14) being spaced apart from one another for air to flow therebetween and into the interior space (25) of the heat exchanger assembly (10);
a second fan assembly (16) disposed vertically above the second heat exchanger panel (14), the second fan assembly (16) comprising:
a fan impeller (36) rotatable about a second fan rotation axis (FA) to pull air into the interior space (25) of the heat exchanger assembly (10) through the second heat exchanger panel (14) and evacuate heated air upwardly from the interior space (25) of the heat exchanger assembly (10) through the second fan assembly (16);
and
a second sound dampening device (550) disposed within the interior space (25) of the heat exchanger assembly (10) such that air is pulled into the interior space (25) through the second heat exchanger panel (14) and then flows through the second sound dampening device (550) before being discharged from the heat exchanger assembly (10) via the second fan assembly (16), the second sound dampening device (550) comprising:
a plurality of baffle members (600₁-600₅), the baffle members (600₁-600₅) of the second sound dampening device (550) being spaced apart from one another for allowing air flow therebetween, each of the baffle members (600₁-600₅) of the second sound dampening device (550) extending at an angle relative to a plane extending through the upper and lower ends (26, 24) of the second heat exchanger panel (14) so as to direct air flow upwardly toward the second fan assembly (16).

14. The heat exchanger assembly of claim 13, wherein the frame (12) comprises:
a first leg (1030) and a second leg (1030) laterally spaced apart from the first leg (1030);
at least one lower transversal member (1035) extending laterally and interconnecting the first and second legs;
a first upstanding member (1036) and a second upstanding member (1036) laterally spaced apart from the first upstanding member (1036), the first and second upstanding members (1036) extending upwardly from the first and second legs (1030);
an upper transversal member (1038) extending laterally and connected to upper ends (1051) of the first and second upstanding members (1036); and
an upper frame assembly (1045) affixed to the upper transversal member (1038) and supporting the first and second fan assemblies (16),
wherein:
the first and second heat exchanger panels (14) are disposed on opposite sides of a vertical plane extending through the first and second upstanding members (1036); and
the first fan rotation axis (FA) and the second fan rotation axis (FA) are disposed on opposite sides of the vertical plane extending through the first and second upstanding members (1036).

15. The heat exchanger of any one of claims 1 to 12, wherein the baffle members (600₁-600₅) each comprises a sound absorbing material (215) covered at least in part by a protecting layer (217), the sound absorbing material (215) being one of: a foam material, fiberglass, mineral wool and cotton.

## Patentansprüche

1. Wärmetauscherbaugruppe (10), umfassend:
ein Gestell (12);
eine Wärmetauscherplatte (14), die an dem Gestell (12) montiert ist und so konfiguriert ist, dass sie mit der Luft, die dadurch strömt, Wärme austauscht, wobei die Wärmetauscherplatte (14) ein unteres Ende (24) und ein oberes Ende (26) aufweist, wobei die Wärmetauscherplatte (14) in einer geneigten Ausrichtung angeordnet ist, so dass das obere und das untere Ende (26, 24) davon zueinander versetzt sind, wobei die Wärmetauscherplatte (14) Folgendes umfasst:
eine Röhrenanordnung (28) zum Umwälzen von Fluid darin; und
eine Vielzahl von Rippen (33) in thermischem Kontakt mit der Röhrenanordnung (28), wobei die Rippen (33) voneinander beabstandet sind, damit Luft dazwischen und in einen Innenraum (25) der Wärmetauscherbaugruppe (10) strömen kann;
eine Vielzahl von Umfassungsplatten (18, 19), die mit dem Gestell (12) verbunden ist und zum Teil den Innenraum (25) der Wärmetauscherbaugruppe (10) definieren;
eine Gebläsebaugruppe (16), die vertikal über der Wärmetauscherplatte (14) angeordnet ist, wobei die Gebläsebaugruppe (16) ein Gebläserad (36) umfasst, das um eine Gebläserotationsachse (FA) drehbar ist, um Luft in den Innenraum (25) der Wärmetauscherbaugruppe (10) durch die Wärmetauscherplatte (14) zu ziehen und erwärmte Luft aus dem Innenraum (25) der Wärmetauscherbaugruppe (10) durch die Gebläsebaugruppe (16) nach oben zu entleeren;
**gekennzeichnet durch**:
eine schalldämpfende Einrichtung (550), die innerhalb des Innenraums (25) der Wärmetauscherbaugruppe (10) angeordnet ist, so dass Luft in den Innenraum (25) durch die Wärmetauscherplatte (14) gezogen wird und dann durch die schalldämpfende Einrichtung (550) strömt, bevor sie aus der Wärmetauscherbaugruppe (10) über die Gebläsebaugruppe (16) abgegeben wird, wobei die schalldämpfende Einrichtung (550) Folgendes umfasst:
eine Vielzahl von Prallelementen (600₁-600₅), wobei die Prallelemente (600₁-600₅) so voneinander beabstandet sind, dass sie es ermöglichen, dass Luft dazwischen strömt, wobei sich jedes der Prallelemente (600₁-600₅) in einem Winkel relativ zu einer Ebene erstreckt, die durch das obere und das untere Ende (26, 24) der Wärmetauscherplatte (14) verläuft, so dass ein Luftstrom nach oben zur Gebläsebaugruppe (16) gelenkt wird.

2. Wärmetauscherbaugruppe nach Anspruch 1, wobei:
jedes der Prallelemente (600₁-600₅) einen ersten Abschnitt (602) und einen zweiten Abschnitt (604) aufweist, der sich von dem ersten Abschnitt (602) aus erstreckt;
der erste Abschnitt (602) näher an der Wärmetauscherplatte (14) angeordnet ist als der zweite Abschnitt (602), so dass sich Luft, die in die Wärmetauscherbaugruppe (10) gezogen wird und durch die schalldämpfende Einrichtung (550) strömt, entlang des ersten Abschnitts (602) jedes der Prallelemente (600₁-600₅) bewegt, bevor sie den zweiten Abschnitt (604) davon erreicht; und
sich der zweite Abschnitt (604) nach oben in einem Winkel relativ zu dem ersten Abschnitt (602) erstreckt, um einen Luftstrom abzulenken, der von einer Richtung des ersten Abschnitts (602) einströmt.

3. Wärmetauscherbaugruppe nach Anspruch 2, wobei sich der zweite Abschnitt (604) jedes Prallelements (600₁-600₅) im Allgemeinen vertikal erstreckt.

4. Wärmetauscherbaugruppe nach Anspruch 2 oder 3, wobei sich der erste Abschnitt (602) jedes Prallelements (600₁-600₅) in einem Winkel zwischen 40° und einschließlich 75° relativ zu einer horizontalen Ebene erstreckt.

5. Wärmetauscherbaugruppe nach einem der Ansprüche 1 bis 4, wobei ein Abstand (617) zwischen aufeinanderfolgenden einen der Prallelemente (600₁-600₅) variabel ist.

6. Wärmetauscherbaugruppe nach einem der Ansprüche 1 bis 5, wobei:
jedes der Prallelemente (600₁-600₅) ein oberes Ende (608) und ein unteres Ende (606) aufweist; und
das untere Ende (606) eines bestimmten einen der Prallelemente (600₁-600₅) vertikal tiefer als das obere Ende (608) eines nachfolgenden einen der Prallelemente (600₁-600₅) angeordnet ist, das unter dem bestimmten einen der Prallelemente (600₁-600₅) angeordnet ist.

7. Wärmetauscherbaugruppe nach einem der Ansprüche 1 bis 6, wobei:
die Prallelemente (600₁-600₅) erste Prallelemente sind;
die schalldämpfende Einrichtung (550) ferner Folgendes umfasst: eine Vielzahl von zweiten Prallelementen (500₁-500₅), die an den ersten Prallelementen (600₁-600₅) befestigt ist, wobei sich die zweiten Prallelemente (500₁-500₅) senkrecht zu den ersten Prallelementen (600₁-600₅) und zu der Ebene, die durch das obere und das untere Ende (26, 24) der Wärmetauscherplatte (14) verläuft, erstrecken, wobei die zweiten Prallelemente (500₁-500₅) voneinander beabstandet sind, wobei die ersten Prallelemente (600₁-600₅) und die zweiten Prallelemente (500₁-500₅) Luftkanäle (630) dazwischen ausbilden.

8. Wärmetauscherbaugruppe nach Anspruch 7, wobei die ersten Prallelemente (600₁-600₅) und die zweiten Prallelemente (500₁-500₅) ein rechteckiges Gitter bilden, das die Luftkanäle (630) definiert.

9. Wärmetauscherbaugruppe nach Anspruch 7 oder 8, wobei jedes der zweiten Prallelemente (500₁-500₅) eine im Allgemeinen dreieckige Form aufweist.

10. Wärmetauscherbaugruppe nach Anspruch 9, wobei jedes der zweiten Prallelemente (500₁-500₅) Folgendes umfasst:
eine erste Kante (508);
eine zweite Kante (510), die sich senkrecht zur ersten Kante (508) erstreckt; und
eine dritte Kante (506), die sich diagonal in Bezug auf die erste und die zweite Kante (508, 510) erstreckt,
wobei die dritte Kante (506) an die Wärmetauscherplatte (14) angrenzt.

11. Wärmetauscherbaugruppe nach einem der Ansprüche 7 bis 10, wobei ein Abstand (517) zwischen aufeinanderfolgenden einen der zweiten Prallelemente (500₁-500₅) variabel ist.

12. Wärmetauscherbaugruppe nach einem der Ansprüche 1 bis 11, ferner Folgendes umfassend:
eine Vielzahl von Akustikplatten (285, 287), die mit den Umfassungsplatten (18, 19) verbunden ist, um den Innenraum (25) der Wärmetauscherbaugruppe (10) akustisch zu isolieren.

13. Wärmetauscherbaugruppe nach einem der Ansprüche 1 bis 12, wobei:
die Wärmetauscherplatte (14) eine erste Wärmetauscherplatte (14) ist;
die Gebläsebaugruppe (16) eine erste Gebläsebaugruppe ist, und
die Gebläserotationsachse eine erste Gebläserotationsachse ist;
die schalldämpfende Einrichtung (550) eine erste schalldämpfende Einrichtung ist; und
die Wärmetauscherbaugruppe (10) ferner Folgendes umfasst:
eine zweite Wärmetauscherplatte (14), die an dem Gestell (12) montiert ist und so konfiguriert ist, dass sie mit der Luft, die dadurch strömt, Wärme austauscht, wobei die zweite Wärmetauscherplatte (14) ein unteres Ende (24) und ein oberes Ende (26) aufweist, wobei die zweite Wärmetauscherplatte (14) in einer geneigten Ausrichtung angeordnet ist, so dass das obere und das untere Ende (26, 24) davon zueinander versetzt sind,
wobei die erste und die zweite Wärmetauscherplatte (14) in einer V-Konfiguration angeordnet sind, so dass ein Abstand zwischen den oberen Enden (26) der ersten und der zweiten Wärmetauscherplatte (14) größer ist als ein Abstand zwischen den unteren Enden (24) der ersten und der zweiten Wärmetauscherplatte (14), wobei die zweite Wärmetauscherplatte (14) Folgendes umfasst:
eine Röhrenanordnung (28) zum Umwälzen von Fluid darin; und
eine Vielzahl von Rippen (33) in thermischem Kontakt mit der Röhrenanordnung (28) der zweiten Wärmetauscherplatte (14), wobei die Rippen (33) der zweiten Wärmetauscherplatte (14) voneinander beabstandet sind, damit Luft dazwischen und in einen Innenraum (25) der Wärmetauscherbaugruppe (10) strömen kann;
eine zweite Gebläsebaugruppe (16), die vertikal über der zweiten Wärmetauscherplatte (14) angeordnet ist, wobei die zweite Gebläsebaugruppe (16) Folgendes umfasst:
ein Gebläserad (36), das um eine zweite Gebläserotationsachse (FA) drehbar ist, um Luft in den Innenraum (25) der Wärmetauscherbaugruppe (10) durch die zweite Wärmetauscherplatte (14) zu ziehen und erwärmte Luft aus dem Innenraum (25) der Wärmetauscherbaugruppe (10) durch die zweite Gebläsebaugruppe (16) nach oben zu entleeren;
und
eine zweite schalldämpfende Einrichtung (550), die innerhalb des Innenraums (25) der Wärmetauscherbaugruppe (10) angeordnet ist, so dass Luft in den Innenraum (25) durch die zweite Wärmetauscherplatte (14) gezogen wird und dann durch die zweite schalldämpfende Einrichtung (550) strömt, bevor sie aus der Wärmetauscherbaugruppe (10) über die zweite Gebläsebaugruppe (16) abgegeben wird, wobei die zweite schalldämpfende Einrichtung (550) Folgendes umfasst:
eine Vielzahl von Prallelementen (600₁-600₅), wobei die Prallelemente (600₁-600₅) der zweiten schalldämpfenden Einrichtung (550) so voneinander beabstandet sind, dass sie es ermöglichen, dass Luft dazwischen strömt, wobei sich jedes der Prallelemente (600₁-600₅) der zweiten schalldämpfenden Einrichtung (550) in einem Winkel relativ zu einer Ebene erstreckt, die durch das obere und das untere Ende (26, 24) der zweiten Wärmetauscherplatte (14) verläuft, so dass ein Luftstrom nach oben zur zweiten Gebläsebaugruppe (16) gelenkt wird.

14. Wärmetauscherbaugruppe nach Anspruch 13, wobei das Gestell (12) Folgendes umfasst:
einen ersten Schenkel (1030) und einen zweiten Schenkel (1030),
der seitlich von dem ersten Schenkel (1030) beabstandet ist;
mindestens ein unteres Querelement (1035), das sich seitlich erstreckt und den ersten und den zweiten Schenkel miteinander verbindet;
ein erstes stehendes Element (1036) und ein zweites stehendes Element (1036), das von dem ersten stehenden Element (1036) seitlich beabstandet ist, wobei sich das erste und das zweite stehende Element (1036) von dem ersten und dem zweiten Schenkel (1030) nach oben erstrecken;
ein oberes Querelement (1038), das sich seitlich erstreckt und mit den oberen Enden (1051) des ersten und des zweiten stehenden Elements (1036) verbunden ist; und
eine obere Gestellbaugruppe (1045), die an dem oberen Querelement (1038) befestigt ist und die erste und die zweite Gebläsebaugruppe (16) stützt,
wobei:
die erste und die zweite Wärmetauscherplatte (14) auf gegenüberliegenden Seiten einer vertikalen Ebene, die durch das erste und das zweite stehende Element (1036) verläuft, angeordnet sind; und
die erste Gebläserotationsachse (FA) und die zweite Gebläserotationsachse (FA) auf gegenüberliegenden Seiten der vertikalen Ebene, die durch das erste und das zweite stehende Element (1036) verläuft, angeordnet sind.

15. Wärmetauscher nach einem der Ansprüche 1 bis 12, wobei die Prallelemente (600₁-600₅) jeweils ein schallabsorbierendes Material (215) umfassen, das mindestens teilweise mit einer Schutzschicht (217) abgedeckt ist, wobei das schallabsorbierende Material (215) eines der Folgenden ist: ein Schaumstoffmaterial, Glasfasern, Mineralwolle und Baumwolle.

## Revendications

1. Ensemble échangeur thermique (10), comprenant :
un cadre (12) ;
un panneau échangeur thermique (14) monté sur le cadre (12) et conçu pour échanger de la chaleur avec de l'air s'écoulant à travers celui-ci, le panneau échangeur thermique (14) ayant une extrémité inférieure (24) et une extrémité supérieure (26), le panneau échangeur thermique (14) étant disposé au niveau d'une orientation inclinée de telle sorte que les extrémités supérieure et inférieure (26, 24) de celui-ci soient décalées l'une par rapport à l'autre, le panneau échangeur thermique (14) comprenant :
un agencement de tubes (28) pour faire circuler un fluide dans celui-ci ; et
une pluralité d'ailettes (33) en contact thermique avec l'agencement de tubes (28), les ailettes (33) étant espacées les unes des autres pour que de l'air s'écoule entre celles-ci et dans un espace intérieur (25) de l'ensemble échangeur thermique (10) ;
une pluralité de panneaux enfermants (18, 19) reliés au cadre (12) et définissant en partie l'espace intérieur (25) de l'ensemble échangeur thermique (10) ;
un ensemble ventilateur (16) disposé verticalement au-dessus du panneau échangeur thermique (14), l'ensemble ventilateur (16) comprenant une turbine de ventilateur (36) pouvant tourner autour d'un axe de rotation de ventilateur (FA) pour extraire de l'air dans l'espace intérieur (25) de l'ensemble échangeur thermique (10) à travers le panneau échangeur thermique (14) et évacuer de l'air chauffé vers le haut à partir de l'espace intérieur (25) de l'ensemble échangeur thermique (10) à travers l'ensemble ventilateur (16) ;
**caractérisé par** :
un dispositif d'amortissement de son (550) disposé dans l'espace intérieur (25) de l'ensemble échangeur thermique (10) de telle sorte que de l'air soit extrait dans l'espace intérieur (25) à travers le panneau échangeur thermique (14) et s'écoule ensuite à travers le dispositif d'amortissement de son (550) avant d'être évacué à partir de l'ensemble échangeur thermique (10) via l'ensemble ventilateur (16), le dispositif d'amortissement de son (550) comprenant :
une pluralité d'éléments déflecteurs (600₁ à 600₅), les éléments déflecteurs (600₁ à 600₅) étant espacés les uns des autres pour permettre un écoulement d'air entre ceux-ci, chacun des éléments déflecteurs (600₁ à 600₅) s'étendant à un angle par rapport à un plan s'étendant à travers les extrémités supérieure et inférieure (26, 24) du panneau échangeur thermique (14) de façon à diriger un écoulement d'air vers le haut vers l'ensemble ventilateur (16).

2. Ensemble échangeur thermique selon la revendication 1, dans lequel :
chacun des éléments déflecteurs (600₁ à 600₅) a une première portion (602) et une seconde portion (604) s'étendant à partir de la première portion (602) ;
la première portion (602) est positionnée plus près du panneau échangeur thermique (14) que la seconde portion (602) de telle sorte que de l'air extrait dans l'ensemble échangeur thermique (10) et s'écoulant à travers le dispositif d'amortissement de son (550) traverse le long de la première portion (602) de chacun des éléments déflecteurs (600₁ à 600₅) avant d'atteindre la seconde portion (604) de celui-ci ; et
la seconde portion (604) s'étend vers le haut à un angle par rapport à la première portion (602) pour dévier un écoulement d'air entrant à partir d'une direction de la première portion (602) .

3. Ensemble échangeur thermique selon la revendication 2, dans lequel la seconde portion (604) de chaque élément déflecteur (600₁ à 600₅) s'étend généralement verticalement.

4. Ensemble échangeur thermique selon la revendication 2 ou 3, dans lequel la première portion (602) de chaque élément déflecteur (600₁ à 600₅) s'étend à un angle entre 40° et 75° inclus par rapport à un plan horizontal.

5. Ensemble échangeur thermique selon l'une quelconque des revendications 1 à 4, dans lequel un espacement (617) entre des consécutifs parmi les éléments déflecteurs (600₁ à 600₅) est variable.

6. Ensemble échangeur thermique selon l'une quelconque des revendications 1 à 5, dans lequel :
chacun des éléments déflecteurs (600₁ à 600₅) a une extrémité supérieure (608) et une extrémité inférieure (606) ; et
l'extrémité inférieure (606) d'un donné parmi les éléments déflecteurs (600₁ à 600₅) est positionnée verticalement plus bas que l'extrémité supérieure (608) d'un consécutif parmi les éléments déflecteurs (600₁ à 600₅) positionné en dessous du donné parmi les éléments déflecteurs (600₁ à 600₅).

7. Ensemble échangeur thermique selon l'une quelconque des revendications 1 à 6, dans lequel :
les éléments déflecteurs (600₁ à 600₅) sont des premiers éléments déflecteurs ;
le dispositif d'amortissement de son (550) comprend en outre : une pluralité de seconds éléments déflecteurs (500₁ à 500₅) attachés aux premiers éléments déflecteurs (600₁ à 600₅), les seconds éléments déflecteurs (500₁ à 500₅) s'étendant perpendiculaires aux premiers éléments déflecteurs (600₁ à 600₅) et au plan s'étendant à travers les extrémités supérieure et inférieure (26, 24) du panneau échangeur thermique (14), les seconds éléments déflecteurs (500₁ à 500₅) étant espacés les uns des autres, les premiers éléments déflecteurs (600₁ à 600₅) et les seconds éléments déflecteurs (500₁ à 500₅) formant des conduits d'air (630) entre ceux-ci.

8. Ensemble échangeur thermique selon la revendication 7, dans lequel les premiers éléments déflecteurs (600₁ à 600₅) et les seconds éléments déflecteurs (500₁ à 500₅) forment une grille rectangulaire définissant les conduits d'air (630).

9. Ensemble échangeur thermique selon la revendication 7 ou 8, dans lequel chacun des seconds éléments déflecteurs (500₁ à 500₅) a une forme généralement triangulaire.

10. Ensemble échangeur thermique selon la revendication 9, dans lequel chacun des seconds éléments déflecteurs (500₁ à 500₅) comprend :
un premier bord (508) ;
un deuxième bord (510) s'étendant perpendiculairement au premier bord (508) ; et
un troisième bord (506) s'étendant en diagonale par rapport aux premier et second bords (508, 510),
le troisième bord (506) étant adjacent au panneau échangeur thermique (14).

11. Ensemble échangeur thermique selon l'une quelconque des revendications 7 à 10, dans lequel un espacement (517) entre des consécutifs parmi les seconds éléments déflecteurs (500₁ à 500₅) est variable.

12. Ensemble échangeur thermique selon l'une quelconque des revendications 1 à 11, comprenant en outre :
une pluralité de panneaux acoustiques (285, 287) reliés aux panneaux enfermants (18, 19) pour isoler acoustiquement l'espace intérieur (25) de l'ensemble échangeur thermique (10).

13. Ensemble échangeur thermique selon l'une quelconque des revendications 1 à 12, dans lequel :
le panneau échangeur thermique (14) est un premier panneau échangeur thermique (14) ;
l'ensemble ventilateur (16) est un premier ensemble ventilateur, et l'axe de rotation de ventilateur est un premier axe de rotation de ventilateur ;
le dispositif d'amortissement de son (550) est un premier dispositif d'amortissement de son ; et
l'ensemble échangeur thermique (10) comprend en outre :
un second panneau échangeur thermique (14) monté sur le cadre (12) et conçu pour échanger de la chaleur avec de l'air s'écoulant à travers celui-ci, le second panneau échangeur thermique (14) ayant une extrémité inférieure (24) et une extrémité supérieure (26), le second panneau échangeur thermique (14) étant disposé au niveau d'une orientation inclinée de telle sorte que les extrémités supérieure et inférieure (26, 24) de celui-ci soient décalées l'une par rapport à l'autre, les premier et second panneaux échangeurs thermiques (14) étant disposés dans une configuration en V de telle sorte qu'une distance entre les extrémités supérieures (26) des premier et second panneaux échangeurs thermiques (14) soit plus grande qu'une distance entre les extrémités inférieures (24) des premier et second panneaux échangeurs thermiques (14), le second panneau échangeur thermique (14) comprenant :
un agencement de tubes (28) pour faire circuler un fluide dans celui-ci ; et
une pluralité d'ailettes (33) en contact thermique avec l'agencement de tubes (28) du second panneau échangeur thermique (14), les ailettes (33) du second panneau échangeur thermique (14) étant espacées les unes des autres pour que de l'air s'écoule entre celles-ci et dans l'espace intérieur (25) de l'ensemble échangeur thermique (10) ;
un second ensemble ventilateur (16) disposé verticalement au-dessus du second panneau échangeur thermique (14), le second ensemble ventilateur (16) comprenant :
une turbine de ventilateur (36) pouvant tourner autour d'un second axe de rotation de ventilateur (FA) pour extraire de l'air dans l'espace intérieur (25) de l'ensemble échangeur thermique (10) à travers le second panneau échangeur thermique (14) et évacuer de l'air chauffé vers le haut à partir de l'espace intérieur (25) de l'ensemble échangeur thermique (10) à travers le second ensemble ventilateur (16) ; et
un second dispositif d'amortissement de son (550) disposé dans l'espace intérieur (25) de l'ensemble échangeur thermique (10) de telle sorte que de l'air soit extrait dans l'espace intérieur (25) à travers le second panneau échangeur thermique (14) et s'écoule ensuite à travers le second dispositif d'amortissement de son (550) avant d'être évacué à partir de l'ensemble échangeur thermique (10) via le second ensemble ventilateur (16), le second dispositif d'amortissement de son (550) comprenant :
une pluralité d'éléments déflecteurs (600₁ à 600₅), les éléments déflecteurs (600₁ à 600₅) du second dispositif d'amortissement de son (550) étant espacés les uns des autres pour permettre un écoulement d'air entre ceux-ci, chacun des éléments déflecteurs (600₁ à 600₅) du second dispositif d'amortissement de son (550) s'étendant à un angle par rapport à un plan s'étendant à travers les extrémités supérieure et inférieure (26, 24) du second panneau échangeur thermique (14) de façon à diriger un écoulement d'air vers le haut vers le second ensemble ventilateur (16).

14. Ensemble échangeur thermique selon la revendication 13, dans lequel le cadre (12) comprend :
une première patte (1030) et une seconde patte (1030) espacée latéralement de la première patte (1030) ;
au moins un élément transversal inférieur (1035) s'étendant latéralement et raccordant les première et seconde pattes ;
un premier élément droit (1036) et un second élément droit (1036) espacé latéralement du premier élément droit (1036), les premier et second éléments droits (1036) s'étendant vers le haut à partir des première et seconde pattes (1030) ;
un élément transversal supérieur (1038) s'étendant latéralement et relié à des extrémités supérieures (1051) des premier et second éléments droits (1036) ; et
un ensemble cadre supérieur (1045) attaché à l'élément transversal supérieur (1038) et supportant les premier et second ensembles ventilateurs (16),
dans lequel :
les premier et second panneaux échangeurs thermiques (14) sont disposés sur des côtés opposés d'un plan vertical s'étendant à travers les premier et second éléments droits (1036) ; et
le premier axe de rotation de ventilateur (FA) et le second axe de rotation de ventilateur (FA) sont disposés sur des côtés opposés du plan vertical s'étendant à travers les premier et second éléments droits (1036).

15. Échangeur thermique selon l'une quelconque des revendications 1 à 12, dans lequel les éléments déflecteurs (600₁ à 600₅) comprennent chacun un matériau absorbant phonique (215) couvert au moins en partie par une couche de protection (217), le matériau absorbant phonique (215) étant un parmi : un matériau alvéolaire, de la fibre de verre, de la laine minérale et du coton.
